# EUROPEAN PATENT SPECIFICATION

(11) **EP 0 441 308 B1**
(45) Date of publication and mention of the grant of the patent: **20.12.1995**
(21) Application number: 91101500.6
(22) Date of filing: 05.02.1991
(51) Int. Cl.: G03F 7/038, H05K 3/42

(54) **Process for preparing printed circuit board having through-hole**
Verfahren zur Herstellung einer gedruckten Schaltung mit Loch
Procédé de production d'une plaquette à circuit imprimé à trou

(30) Priority: 07.02.1990 JP 26009/90
(43) Date of publication of application: 14.08.1991
(73) Proprietor: NIPPON OIL CO., LTD., Tokyo (JP)
(72) Inventor: Yuasa, Hitoshi, Yokohama-shi, Kanagawa-ken (JP); Sato, Haruyoshi, Kawasaki-shi, Kanagawa-ken (JP); Yamasita, Yukio, Yokohama-shi, Kanagawa-ken (JP); Yoda, Eiji, Yokohama-shi, Kanagawa-ken (JP); Otsuki, Yutaka, Konan-ku, Yokohama-shi, Kanagawa-ken (JP)
(74) Representative: Patentanwälte Hauck, Graalfs, Wehnert, Döring, Siemons

(56) References cited:
- EP-A- 0 127 689
- EP-A- 0 353 924
- EP-A- 0 383 223

## Description

### BACKGROUND OF THE INVENTION:

The present invention relates generally to a printed circuit board, and particularly to a process for the production of a so-called through-hole printed circuit board which has at least one through-hole or like pierced bore having interior surface or periphery plated or otherwise applied with an electrically conductive metal to connect a printed circuit on one surface to a circuit on the opposite surface.

While being accompanied with the progress of surprising development in the technology relating to electronic instruments, there is an increasing demand or request for further densification and integration of printed circuit board so as to arrange finer circuit patterns on such a board. Higher densification of the printed circuit board may be realized by the formation of finer circuit patterns and the provision of multi-layered structure. However, there are many additional hurdles which should be cleared for satisfying such a demand. As one of such hurdles, a metal conductor layer in the interior peripheries of through-holes or via-holes which extend through the board from one surface to the other surface to provide passages must be fully protected not to contact with an etching solution during the etching step for the formation of a desired circuit pattern. As the size of the circuit pattern becomes smaller in the micrometer order, the inner diameters of through-holes or via-holes become smaller correspondingly, and there often arises a need for a printed circuit board having via-holes each having an inner diameter of 100 »m or so. To cope with such a need, it is now hastened in the art to develop a method of coating a uniform and thin etching resist which can protect the interior peripheries of through-holes or via-holes, and as one of such a method, a method for coating an etching resist by electrodeposition has been proposed recently to provide substitution means for the existing dry film. However, in general, none of the methods of prior proposals for coating etching resists, in which electrodeposition techniques were utilized, provide satisfactory means for the production of a minute and delicate circuit pattern. For example, a process for forming a circuit pattern while making use of a negative electrodeposit photoresist has been proposed and proved that it is in fact suitable for the production of fine circuit patterns. However, the process has a disadvantage that the green coating material for forming the negative electrodeposit photoresist could not be cured to a sufficient extent to ensure reliable protection of the metal conductor layer in the interior periphery of each through-hole or via-hole, since portions of the green coating material infiltrating into respective through-holes to cover the metal conductor layer are not exposed to a sufficient quantity of light. On the other hand, although the method making use of a positive electrodeposit photoresist having positive photosensitive groups, such as naphtoquinone diazide groups, is suited for the protection of the interior walls of through-holes, it has a problem that a fine circuit pattern cannot be formed due to insufficient photosensitivity. The method has another problem that the application thereof for industrial scale production is difficult since handling of the positive electrodeposit resist in practical operation poses various difficulties, for example, due to the problem that the solution used in the electrodeposition step is not stable for a long period of time.

Proposed by Japanese Patent Publication No. 36198/1980 is a process for preparing a fine circuit pattern while protecting the interiors of through-holes. This process comprises the steps of forming a resist layer arranged in a pattern which is reverse to or complementary to the circuit pattern to be formed finally while using an alkali-soluble ink; depositing a solvent-soluble resist layer on the exposed portion or portions of the conductor, including the interior walls of through-holes, on which no adhering layer of the resist are applied thereby to protect the exposed portion or portions; removing the ink forming the complementary pattern; removing the portion or portions of the conductor; and removing the electrodeposited resist layer by peeling off the same. This process is an interesting process in its principal concept for overcoming the problems of negative and positive electrodeposit resists as described above. However, this method also involves some serious problems or troubles which hinder the practical application thereof on industrial scale. Particularly, when a circuit pattern is formed following the procedure as aforementioned, since an ink which is removed by an alkali is employed to form a negative pattern, the positive resist layer applied to cover the desired final pattern must be completely cured by heating or other appropriate means so that the cured resist layer becomes resistant to an aqueous alkali solution. Thus, it is naturally required to use a solvent for the striping and removal of the cured film, and in addition, there might arise a case where a portion of the cured film is left unremoved to obstract formation of fine and precise circuit patterns. This poses a serious problem when the process is applied for industrial use.

### SUMMARY OF THE INVENTION:

Accordingly, an object of this invention is to provide a process for the production of a through-hole printing circuit board, by which very fine circuit patterns of micrometer order can be formed stably and easily on an industrial scale while reliably protecting the electrically conductive metal layers or liners applied in the inner walls of through-holes and/or via-holes.

Another object of this invention is to provide a process for the production of a through-hole printed circuit board, the process being capable of being performed in a better environment for the operators.

The above and other objects of the invention will become apparent from the following description.

According to a principal aspect of the invention, provided is a process for preparing a through-hole printed circuit board having at least one through-hole, comprising the steps of:
(a) applying an acid-soluble cationic electrodeposit photoresist by electrodeposition all over on a surface of a board covered by an electrically conductive metal layer including the through-hole, while setting the board as a cathode;
(b) heating the board passed through the step (a) to a tempeature of from 50°C to 120°C;
(c) exposing the acid-soluble cationic electrodeposit photoresist to light through a photo-mask having a pattern complementary to a pattern of a circuit to be formed on the board, thereby to cure the photoresist, and then developing with a developer to remove only an uncured portion of the photoresist;
(d) applying an alkali-soluble anionic electrodeposit etching resist by electrodeposition on a surface of a portion of the electrically conductive metal layer uncoated with the cured photoresist, while setting the board passed through the step (c) as an anode;
(e) heating the board passed through the step (d) to a tempeature of from 50 to 120°C;
(f) removing a coating of the cured acid-soluble cationic electrodeposit photoresist with an aqueous acid solution;
(g) etching a portion of the electrically conductive metal layer exposed by the preceding step (f); and
(h) removing the remaining alkali-soluble anionic electrodeposit etching resist with an aqueous alkali solution.

### PREFERRED EMBODIMENTS OF THE INVENTION:

The present invention will now be described more in detail by explaining the operation sequence step by step.

Initially, in the step (a), an acid-soluble cationic electrodeposit photoresist is applied by electrodeposition all over on the surface of a board covered by an electrically conductive layer or layers including a through-hole or holes, while setting the board as the cathode.

As an example of the boards used for the aforementioned purpose, there may be mentioned a composite material prepared by plating the surface of a glass fiber reinforced epoxy resin layer, provided with one or more through-holes by any of the known processing, with a conductive metal, such as copper, and then laminating plural glass fiber reinforced epoxy resin layers.

Preferable examples of the acid-soluble cationic electrodeposit photoresist include cathode-depositing type negative photoresists. Representative examples of the acid-soluble cationic electrodeposit photoresist include a photoresist containing a resin having amino and (meth)acryl groups, and a photoresist containing a resin having an amino group in combination with a photosensitive prepolymer.

Preferable examples of the photoresist containing therein a resin having amino and (meth)acryl groups include a photoresist containing a (meth)acryl group-containing cationic resin (I) and a photopolymerization initiator. The (meth)acryl group-containing cationic resin (I) may be prepared by reacting a polymer (A) having a molecular weight of from 500 to 5,000, an iodine value of from 50 to 500, carbon-carbon double bonds and 3 to 12 wt% of oxyranic oxygen with an amine compound (B) represented by the following formula (1) of: 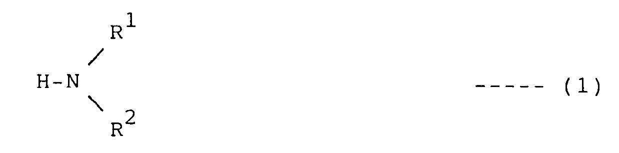
wherein R¹ and R² may be the same or different group and each stands for an organic residue having 1 to 20 carbon atoms or an organic residue having a portion thereof substituted by a hydroxyl group and having 1 to 20 carbon atoms, where a ring-structure may be formed by the groups R¹ and R² and an unsaturated group may be present in the ring structure;
and then further reacting with an α,β-unsaturated carboxylic acid (C) represented by the following formula (2) of: 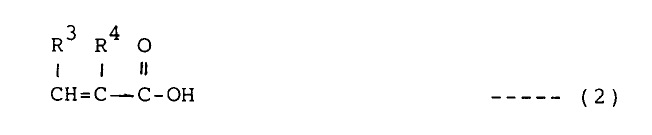
wherein R³ and R⁴ may be the same or different group and each stands for a hydrogen atom or a methyl group.

It is not preferred that either one of the groups R¹ and R² has carbon atoms out of the ranges as defined in the formula (I), since it is rather difficult to prepare such compounds.

The polymer (A) may be prepared, for example, by using an organic polymer having a molecular weight of from 500 to 5,000, an iodine value of from 50 to 500 and carbon-carbon double bonds as a starting material, epoxidizing the starting material through the known method using a peroxide, e.g. hydrogen peroxide or peracids such as performic acid, peracetic acid or m-chloro perbenzoic acid to introduce an oxyranic oxygen group in an amount, as calculated as oxygen, of preferably from 3 to 12 wt%, particularly preferably from 5 to 10 wt%.

The aforementioned starting material may be prepared by any of the known processes and, for example, a typical process is an anion polymerization process of any of conjugated diolefins having 4 to 10 carbon atoms singly, or a copolymerization process of any of the mixtures of these conjugated diolefins or mixtures of these conjugated diolefins mixed with aromatic vinyl monomers, such as styrene, α-methylstyrene, vinyltoluene or divinyl benzene, in a ratio of 50 mol% based on the conjugated diolefin, the anion polymerization or copolymerization being effected at a temperature of from 0°C to 100°C in the presence of a catalyst selected from alkali metals and organoalkali compounds. In practice of the aforementioned anionic polymerization or copolymerization, preferable processes for controlling the molecular weight of the resultant product to obtain a light-colored oligomer containing little gel, include the chain transfer polymerization (USP 3,789,090) in which an organic alkali metal compound, such as sodium benzyl, is used as a catalyst and a compound having an alkylaryl group, such as toluene, is used as a chain transferring agent; the living polymerization in which a polycyclic aromatic compound, such as naphthalene, is used in a solution in tetrahydrofuran as an activator and an alkali metal, such as sodium, is used as a catalyst (Japanese Patent Publication Nos. 17485/1967 and 27432/1968); and the polymerization process in which the molecular weight is controlled by the addition of an ether such as dioxane, while aromatic hydrocarbons such as toluene or xylene are used as a solvent with a dispersion of an alkali metal such as sodium being used as a catalyst (Japanese Patent Publication Nos. 7446/1957, 1245/1963 and 10188/1959). It is also possible to use low molecular weight polymer prepared by the coordination anionic polymerization wherein an acetyl acetonate compound of a Group VIII metal, such as cobalt or nickel, and an alkyl aluminium halogenide are used as the catalyst (Japanese Patent Publication Nos. 507/1970 and 80300/1971).

Examples of the amine compound (B) include aliphatic amines such as dimethylamine and diethylamine; alkanolamines such as methylethanolamine and diethanolamine; and cyclic amines such as morpholine and piperidine.

On the other hand, examples of the α,β-unsaturated carboxylic acid (C) are acrylic acid, methacrylic acid and crotonic acid.

The polymer (A) may be reacted with the amine compound (B), for example, in the presence and absence of a solvent, preferably at a temperature of from 50°C to 200°C; and then further reacted with the α,β-unsaturated carboxylic acid (C) in the presence or absence of a solvent, preferably at a temperature of from 100°C to 200°C to prepare a (meth)acrylic group-containing cationic resin (I). Mixing ratios of respective reactants range such that 100g of the polymer (A) is reacted with preferably from 30 to 300 millimols, more preferably from 50 to 200 millimols of the amine compound (B), and then the α,β-unsaturated carboxylic acid (C) is added to the reaction system so that prferably from 50 to 250 millimols of carboxylic acid is reacted.

The aforementioned addition reactions may be carried out in a non-solvent system, but it is preferable that the addition reactions be carried out in the presence of a solvent. Any solvents may be used as far as they do not affect the reactions, and it is most preferred that a solvent having a hydroxyl group be used. Examples of the hydroxyl group-containing solvents include ethyl cellosolve, butyl cellosolve, phenyl cellosolve, and diethylene glycol dimethyl ether.

Any of the conventional photopolymerization initiators may be used for providing the (meth)acryl group-containing cationic resin (I) prepared as described hereinabove, specific examples being benzoin, benzoin methyl ether, benzoin ethyl ether, benzoin butyl ether, benzyl, and Michler's ketone; and commercially available photopolymerization initiators may also be used, specific examples being "Ingacure 184", "Ingacure 651" and "Ingacure 907" (Trade Names; produced by Ciba-Geigy AG) and "Dalocure 1173" (Trade Name; Merk & Co., Inc.).

It is preferred that the photopolymerization initiator be added in an amount, based on 100 parts by weight of the (meth)acryl group-containing cationic resin (I), of preferably from 0.1 to 15 parts by weight, most preferably from 1 to 10 parts by weight. Inconvenient results might be caused if the amount of the added photopolymerization initiator is out of the defined range. Namely, if the added amount is less than 0.1 part by weight, the curability upon exposure to light is lowered; whereas the strength of the photosensitive coating is reduced if the added amount exceeds 15 parts by weight.

When the composition composed of the (meth)acryl group-containing cationic resin (I) and the photopolymerization initiator is used as the acid-soluble cationic electrodeposit photoresist, it may be dissolved or dispersed in water prior to use thereby to prepare an aqueous solution or dispersion suited for the subsequent electrodeposition. In preparation of an aqueous solution or dispersion, an organic acid, such as formic acid, acetic acid or propionic acid, is added to the composition in an amount of 0.2 to 1.0 molar equivalent to a unit molar equivalent of amino group in the (meth)acryl group-containing cationic resin (I) to neutralize the photoresist composition. The temperature for the preparation of the aqueous solution or dispersion as aforementioned is not particularly limited, and may be, for example within a temperature range of from 0°C to 120°C, or at an ambient temperature.

Moreover, with the aim to facilitate formation of an aqueous solution or dispersion, to improve the stability of the resultant aqueous solution or dispersion and to render the subsequent step (b) more effective, an organic solvent which is water-soluble and yet capable of dissolving the photoresist may be added. Examples of organic solvent suited for such use include ethyl cellosolve, propyl cellosolve, butyl cellosolve, ethylene glycol dimethyl ether, diethylene glycol dimethyl ether, diacetone alcohol, methyl ethyl ketone and mixtures thereof. It is preferred that 10 to 100 parts by weight of such an organic solvent be added to 100 parts by weight of the (meth)acryl group-containing cationic resin (I).

As the acid-soluble cationic electrodeposit photoresist composed of the resin having therein an amino group and the photosensitive prepolymer, the most preferable acid-soluble cationic electrodeposit photoresist contains a polyamine (II) having a group (E) represented by the following formula (3) of: 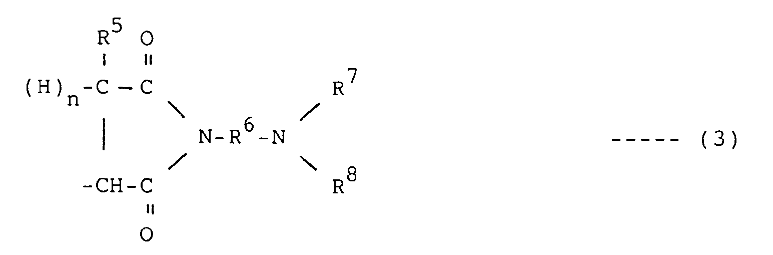
wherein R⁵ stands for a hydrogen atom, a halogen atom or an organic residue having 1 to 3 carbon atoms; R⁶ stands for an alkylene or arylene chain having 1 to 10 carbon atoms; R⁷ and R⁸ may be the same or differnt group and each stands for an organic residue having 1 to 3 carbon atoms; and n is 0 (zero) or 1 and when n is zero a portion of the main chain is formed by both of the carbon atoms, one being bound to R⁵ and the other being adjacent to the one carbon atom and bound to a hydrogen atom;
the group (E) being introduced at least a portion of a double bond of a main chain polymer (D) having a molecular weight of from 300 to 30,000 and an iodine value of from 50 to 500 and including carbon-carbon double bonds; a photosensitive prepolymer (III) having an ethylenic double bond; and a photopolymerization initiator. Meanwhile, it is not preferred that anyone of the groups R⁵, R⁶, R⁷ and R⁸ has carbon atoms out of the ranges as defined in the formula (3), since it becomes rather difficult to prepare the corresponding compounds.

Preferable materials for use as the main chain polymer (D), used in this invention, include for example natural oils and fats, such as linseed oil, tung oil, soybean oil or dehydrated caster oil or so-called stand oils prepared by subjecting these natural oils and fats to heating treatment to increase the molecular weights; oligomers of conjugated diolefins selected from the group consisting of butadiene, isoprene, piperylene, and mixtures thereof, and copolymers of one or more of these conjugated diolefins having low degree of polymerization copolymerized with vinyl monomers each having an ethylenically unsaturated group, specific examples of which are aliphatic or aromatic vinyl monomers, such as isobutylene, diisobutylene, styrene, α-methylstyrene, vinyl toluene and divinyl benzene. The materials enumurated above may be used singly or in combination in the form of a mixture with two or more of the other materials referred to as above.

The oligomers and/or the copolymers, which are used as the starting materials for the main chain polymer (D) described in the preceding paragraph, may be prepared by a similar processes as used for the preparation of the (meth)acryl group-containing cationic resin (I) and described in detail hereinbefore.

In addition to the specific examples of the main chain polymer (D) illustrated previously, conveniently usable material as the main chain polymer (D) are so-called petroleum resins having an unsaturated group and being prepared through cation polymerization of the C₄ to C₁₀ fractions obtained by cracking of petroleum prefeably at a temperature of from 0°C to 100°C while using Friedel-Crafts catalysts, for example, aluminum chloride, boron trifluoride or chelate compounds thereof; and copolymers of butadiene/isobutylene having low degree of polymerization which may be prepared while using a catalyst of the same category.

In preparation of the polyamine (II) by introducing the group (E) represented by the formula (3) into the main chain polymer (D), the polyamine (II) is prepared by the steps of adding an α,β-unsaturated dicarboxylic anhydride selected from the group consisting of maleic anhydride, citraconic anhydride, chloromaleic anhydride and mixtures thereof to the main chain polymer (D); introducing an acid anhydride group represented by the following formula (4) of: 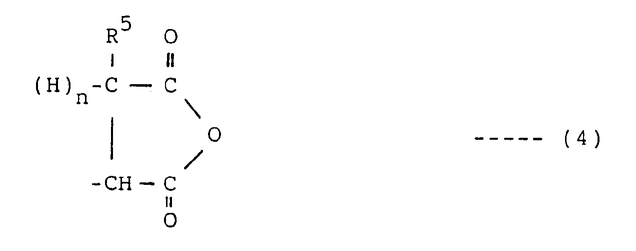
wherein R⁵ stands for a hydrogen atom, a halogen atom or an organic residue having 1 to 3 carbon atoms; and n is 0 (zero) or 1 and when n is zero, a portion of the main chain is formed by both of the carbon atoms, one being bound to R⁵ and the other being adjacent to the one carbon atom and bound to a hydrogen atom;
; reacting then with a hydroxyl group-containing compound (H) represented by the following formula (5) of:

R¹¹OH (5)

wherein R¹¹ is an organic residue having 1 to 12 carbon atoms, preferably an alkyl group having 3 to 10 carbon atoms or -Y′-OR˝, where R˝ is an alkyl group having 1 to 10 carbon atoms and Y′ is an alkylene group having 2 to 3 carbon atoms;
to convert the acid anhydride group represented by the formula (4) set forth above to a half-ester group represented by the following formula (6) of: 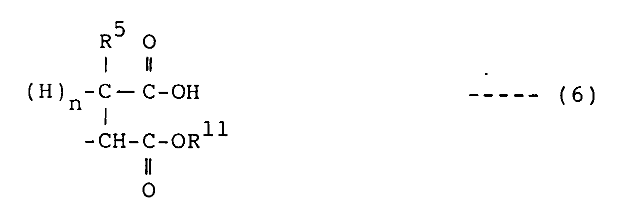
wherein R⁵ , R¹¹ and n are the same as defined in the preceding formula (4) for R⁵ and n, and the same as defined in the formula (5) for R¹¹;
; and thereafter reacting with a diamine compound represented by the formula (7) of: 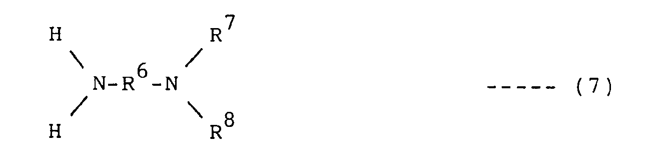
wherein R⁶ is an alkylene or arylene chain having 1 to 10 carbon atoms; and R⁷ and R⁸ are the same or different group and each stands for an organic residue having 1 to 3 carbon atoms.

For the addition of acid anhydride group represented by the formula (4) onto the main chain polymer (D), any of the conventionally known processes may be used (for example, reference should be made to Japanese Patent Publication No. 11195/1971), and a process wherein any of phenylenediamines, pyrogallols, naphthols is present in the reaction system to prevent gelling reaction (see, for example, DE-OS 2362584) may also be conveniently employed in effecting these addition reactions. On the other hand, two or more main chain polymers (D) may be initially mixed followed by addition of the acid anhydride group, or the acid anhydride group may be initially added and then two or more main chain polymers (D) are mixed together. However, in case where addition reaction rates of acid anhydride group to individual main chain polymers (D) are extremely different from one another, it is preferred that mixing of main chain polymers be effected after the completion of addition of acid anhydride group to respective polymers.

It is preferred that the amount of added acid anhydride group represented by the formula (4) ranges generally within 0.05 to 1.5 mols, preferably within 0.1 to 1.2 mols, based on 100g of the main chain polymer (D).

The thus added acid anhydride group may be easily converted to an half ester by reacting the main chain polymer (D), on the portion of which the acid anhydride group has been introduced, with the hydroxyl group-containing compound (H) represented by the formula (5) set forth hereinbefore. The reaction temperature of this step may generally range from - (minus) 10°C to 300°C, and a temprature not lower than the temperature of the boiling point of the used hydroxyl group-containing compound may suffice without the need of raising the reaction system to a particularly high temperature, for instance, the reaction being carried out effectively around room temperature (0°C to 40°C). A solvent for the reaction system and/or a catalyst may be used, but the reaction may proceed without them.

Meanwhile, the reaction between the acid anhydride group and the hydroxyl group-containing compound (H) normally halts at the stage of forming a half-ester, thus formation of a diester being rare. However, in the present invention, products having higher molecular weights including a small amount of diesters, in addition to such a half-ester, may be, of course, used.

Although the addition reaction step, in which the hydroxyl group-containing compound (H) is added, is not essential for the production of the polyamine (II), it is preferred to include this step for smooth proceeding of the overall reaction.

Then, the main chain polymer (D), to which the acid anhydride group and/or the half ester are added, may be imidated using a diamine compound represented by the formula (7) set forth before, whereby a polyamine (II) is formed.

Specific examples of the diamine compounds represented by the formula (7) include dimethylaminoethylamine, diethlaminoethylamine, dimethylaminopropylamine, diethylaminopropylamine, dibutylaminopropylamine and 3-morpholinopropylamine.

Although the diamine compound may be used preferably in the equivalent molar amount, based on the acid anhydride group represented by the formula (4) and/or half-ester groups, excessive quantity of diamine may be used followed by removal by distillation of excess diamine.

Imidation, in which a diamine compound is used as aforementioned, may be carried out normally at a temperature of from 50°C to 300°C, preferably from 100°C to 200°C and optionally water produced by imidation may be distilled off from the reaction system to further accelerate the reaction.

Imidation may be effected either in the presence or absence of a solvent. Any solvent need not be used, when the viscosity of the resultant imidated high molecular weight product having half-ester and double bonds is not so high.

In a preferable method for effecting imidation, the acid anhydride group represented by the formula (4) is added to the main chain polymer (D), followed by reaction with the hydroxyl group-containing compound (H) to form a half-ester group, which is immediately subjected to imidation. That is, the main chain polymer (D) to which the acid anhydride group has been introduced is contacted concurrently with the hydroxyl group-containing compound (H) and the diamine compound.

In such a case, it is estimated that a major portion of the acid anhydride group is converted initially to a half-ester group and then reacted with the diamine, since the velocity of the reaction for forming the half-ester group from the acid anhydride group represented by the formula (4) and the hydroxyl group-containing compound (H) is relatively higher. The reaction temperature in such case ranges generally from 50°C to 300°C, preferably from 100°C to 200°C. It is also preferred that the ratio of the used hydroxyl group-containing compound (H) ranges generally from 2 to 200 parts by weight, preferably from 5 to 50 parts by weight, based on 100 parts by weight of the main chain polymer (D). It is convenient to use somewhat excessive, for example fairly excessive, molar equivalent of the hydroxyl group-containing compound (H) in excess of the molar equivalent of the acid anhydride group, so that the former (compound (H)) serves as a solvent.

Typical examples of the hydroxyl group-containing commpound (H) are aliphatic alcohols or partial ethers of polyhydric alcohols.

Examples of the aliphatic alcohols include propanol, butanol, pentanol, heptanol and octanol, and examples of the ethers of polyhydric alcohols include glycol monoethers such as methyl cellosolve, ethyl cellosolve, propyl cellosolve and butyl cellosolve.

Imidation in the presence of an excessive molar ratio of hydroxyl group-containing compound provides considerable advantages that the viscosity of the reaction system is lowered to enable easy handling of the product, and that the solubilizability to water of the product is improved.

Water produced during the imidation reaction does not pose any hindering factor, and thus need not be removed. Meantime, with the purpose of improving tack or other properties of the electrodeposited coating, a portion of the group (E) represented by the formula (3) may be substituted by another imide group having no tertiary amino group.

On the other hand, the prepolymer (III) which is one of the acid-soluble cationic electrodeposit photoresist components is a photosensitive resin having ethylenic double bonds and may be cured by exposing to ultraviolet ray. Specific examples are esters of, for example, epoxy resins, urethane resins, alkyd resins and polyester resins, with acrylic acid or methacrylic acid (these acids will be referred to as "(meth)acrylic acid" in the following description). More specifically, the prepolymer (III) may be, for example, (meth)acrylates of epoxy resins, (meth)acrylates of urethane resins, (meth)acrylates of alkyd resins, (meth)acrylates of polyester resins, particularly preferred being (meth)acrylates of bisphenol type epoxy resins, and (meth)acrylates of novolak type epoxy resins. Examples of the epoxy resins are bisphenol type epoxy resins including bisphenol-A epoxy resins and bisphenol-F epoxy resins; novolak epoxy resins including phenol novolak epoxy resins and cresol novolak epoxy resins; alicyclic epoxy resins, triglycidyl isocyanate, heterocyclic ring-containing epoxy resins, such as hydantoin epoxy, and spiro-ring containing epoxy resins. Examples of commercially available bisphenol type epoxy resins are those sold under the Trade Names of "Epikote 828", "Epikote 834", "Epikote 836", "Epikote 1001", "Epikote 1004" and "Epikote 1007" (produced by Yuka Shell Epoxy K.K.), those sold under the Trade Names of "Araldite 260", "Araldite 280", "Araldite 6071", "Araldite 6084" and "Araldite 6097" (produced by Ciba-Geigy AG). These resins may be used singly or in mixed forms. On the other hand, commercially available products of the novolak epoxy resins includes, for example, those sold under the Trade Names of "Epikote 152", "Epikote 154" and "Epikote 180" (produced by Yuka Shell Epoxy K.K.), those sold under the Trade Names of "Araldite EPN1138", "Araldite EPN1139", "Araldite EON1235", "Araldite EON1273", "Araldite EON1280" and "Araldite EON1299" (produced by Ciba-Geigy AG), and those sold under the Trade Names of "DEN431" and "DEN438" (produced by Dow Chemical Corp.). These resins may be used singly or in mixed forms.

The prepolymers (III) may be prepared through known processes. As one example, preparation of (meth)acrylate of epoxy resin will be described below. The (meth)acrylate of epoxy resin may be prepared, for example, by reacting the epoxy resin with (meth)acrylic acid in the presence of an esterification catalyst at a temperature of preferably from 60°C to 130°C, particularly preferably from 80 to 110°C. The mixing ratio of the epoxy resin to (meth)acrylic acid ranges so that a unit chemical equivalent of epoxy resin is mixed with preferably 0.1 to 1.0 chemical equivalent, most preferably from 0.5 to 1.0 chemical equivalent, of (meth)acrylic acid.

As the esterification catalyst, a known catalyst, such as triphenylphosphine or dimethylbenzylamine, may be used, and it is preferred that the added amount of catalyst ranges generally from 0.5 to 10 wt%, preferably from 0.1 to 5 wt%, based on the total weight of the liquid reaction system.

It is further preferred that a polymerization inhibitor, for example, hydroquinone, 2,4-dimethyl-6-t-butylphenol, p-benzoquinone, phenothiazine, or N-nitrophenylamine, be added to the system for the preparation of such a (meth)acrylate of epoxy resin in a quantity generally ranging from 0.01 to 1 wt%, based on the total weight of the reaction system.

The reaction may be carried out also in an organic solvent which is inert and acts as a viscosity depressant.

Examples of such organic solvent include ketones such as methyl ethyl ketone and cyclohexanone, esters such as ethyl cellosolve acetate and ethyl acetate, ethers such as 1,4-dioxane, tetrahydrofuran, diethylene glycol and dimethyl ether, alcohols such as ethyl cellosolve and phenyl cellosolve, aromatic hydrocarbons such as toluene and xylene and petroleum solvents such as petroleum ether and petroleum naphtha.

Other than the epoxy resins referred to above, glycidylation products of polyvinyl phenol and the like materials may also be used as starting materials for the (meth)acrylates of epoxy resins.

It is preferred that the mixing ratio of the polyamine (II) to the prepolymer (III), by weight basis, be held generally in the range of from 4:1 to 2:3, preferably from 3:1 to 1:1. The mixing ratio out of the defined range is not preferred, since it becomes difficult to form fine patterns. Most preferably, the amine value of the used polyamine (II) is taken into acount when the mixing ratio between the polyamine (II) and the prepolymer (III) is determined. In detail, in order to form a finer pattern, it is particularly preferable to decrease the amount of a certain amine having a relatively high amine value within the defined range, and to increase the mixing ratio of amine when it has a relatively low amine value.

For instance, when a polyamine (II) prepared by adding 0.20 mol of the group (E) represented by the formula (3) to 100g of a main chain polymer (D), it is preferred to control the mixing ratio, by weight basis, of the polyamine (II) to the prepolymer (III) be from 7:3 to 1:1.

A photopolymerization initiator is added to the mixture obtained by mixing the polyamine (II) with the prepolymer (III), followed by dissolving or dispersing in water, to prepare an acid-soluble cationic electrodeposit photoresist. The known photopolymerization initiators as set forth above may be used.

It is preferred that the photopolymerization initiator be added in an amount generally within the range of from 0.1 to 15 parts by weight, particularly preferably within the range of from 1 to 10 parts by weight, based on 100 parts by weight of the mixture of polyamine (II) plus prepolymer (III). The curability upon exposure to light is deteriorated as the added amount of the photopolymerization initiator is less than 0.1 part by weight; whereas the strength of the resultant coating is lowered if the added amount thereof exceeds 15 parts by weight. Thus, it is inconvenient to add the photopolymerization initiator in an amount either less than the lower limit or more than the upper limit of the defined range.

The composition prepared by the procedure as aforementioend and containing the polyamine (II), the prepolymer (III) and the photopolymerization initiator may be formulated, for example, into an aqueous solution or aqueous dispersion, at any time as desired, to be well suited for use in the subsequent electrodeposition, for example, by forming an aquesous solution or dispersion of the composition containing the (meth)acryl group-containing cationic resin and the photopolymerization initiator.

The acid-soluble cationic electrodeposit photoresist may further contain a polymerization inhibitor. Example of the polymerization initiator are hydroquinone, 2,6-di-tert-butyl-paracresol, parabenzoquinone, hydroquinone monomethyl ether, phenothiadine and α-naphtylamine.

It is also possible to add further ingredients, as desired, as far as they do not cause tack in the resultant coating. Examples of such additional ingredients are conventionally known photopolymerizable monomers, including 2-ethylhexyl acrylate, 2-hydroxyethyl acrylate, 1,3-butanediol acrylate, trimethylolpropane triacrylate, pentaerythritol triacrylate, 2-ethylhexyl methacrylate, 2-hydroxyethyl methacrylate, 1,3-butanediol methacrylate, trimethylolpropane trimethacrylate, pentaerythritol methacrylate, or tri(acryloyloxyethyl) isocyanurate. These additional ingredients may be used singly or in combination.

Furthermore, a pigment, such as Phthalocyanine Blue, may be preferably added to improve the operation efficiency.

In the acid-soluble cationic electrodeposit photoresist containing the resin having the amino group and the (meth)acryl group, the prepolymer (III) may be added for the improvement in tack or photosensitivity of the electrodeposited coating.

The hydroxyl group-containing solvent used during the synthesis of the (meth)acryl group-containing cationic resin (I), the polyamine (II) and the prepolymer (III) need not be removed from the system after the completion of reaction, but may be neutralized to have solubility in water. This is because the hydroxyl group-containing solvent has normally both of hydrophilic and oleophilic groups, and thus works extremely effectively for improvement in solubilization of the resin.

The thus-prepared acid-soluble cationic electrodeposit photoresist is applied by electrodeposition all over on the surface of a board covered by an electrically conductive metal layer or layers, including a through-hole or holes, for example, by dipping the board in an aqueous solution or dispersion of the acid-soluble cationic electrodeposit photoresist and then passing direct current, while setting the board as a cathode.

At this electrodeposition step, the thickness of the acid-soluble cationic electrodeposit photoresist coating may be easily controlled by changing the temperature of the solution or dispersion, the time duration for current supply and the current density, thereby to form a coating having an appropriate thickness as selectively determined depending on the intended use. In an illustrative condition for electrodeposition in one example for forming a standard coating thickness of from 5 to 20»m, the temperature of the solution or dispersion is set to 25°C, the time duration for current supply is set to 2 to 3 minutes and the current density is set to 50 mA/dm² (when a constant current is used).

According to the present invention, after the acid-soluble cationic electrodeposit photoresist has been applied over the board at the step (a), the board is subjected to heating treatment at a temperature of from 50°C to 120°C at the subsequent step (b). The heating treatment at this step need be effected within the temperature range as described above and defined in the appended claims in order that the solvent in the electrodeposited coating is removed, while flowing the resist to avoid pinholes to give a uniform coating.

At the subsequent step (c), a photo-mask having a pattern, for example a negative type photo-mask which is reverse or complementary to a pattern of the circuit to be formed on the printed circuit board, is placed on the coating, followed by irradiating a light, for example, ultraviolet ray to cure by photopolymerization a portion or portions exposed to the light, and then developing the coating with a developer, whereby only the uncured portion or portions of the coating are removed so that cured coating covering the exposed portion is left.

Ultraviolet ray may be irradiated, for example, from a high pressure mercury lamp, an ultra-high pressure mercury lamp, a xenon lamp or a metal halide lamp. Development may be effected by spraying a developer on the coating or by dipping the board in a liquid developer. A 1 to 15 wt% aqueous solution of acetic acid, formic acid, propionic acid, lactic acid, sulfuric acid or phosphoric acid may be used as the liquid developer, and a proper surface active agent and/or a water-soluble solvent may be added to the liquid developer. Although the conditions for development are varied depending on the thickness of the coating of the resultant acid-soluble cationic electrodeposit photoresist, and also on the comosition and concentration of the used developer, it is preferred that the developement be effected at a temperature ranging generally from 0°C to 60°C, preferably from 10°C to 50°C, for a time period ranging generally from about 15 seconds to about 5 minutes, preferably from 30 seconds to 2 minutes. Most preferably, development is effected under the condition such that the temperature is lower than the temperature at the step (f) and the time in this step is less than the time at the step (f), as will be seen from the later description relating to the photoresist removal step (f). By selecting proper conditions for respective steps, an aqueous solution of a certain acid may be used as the developer in this step and as a stripper solution in the later step (f).

By serially performing the steps (a) to (c) described above, a photoresist coating formed from a cured acid-soluble photoresist can be left only at the portion or area on the surface of the conductive metal layer or layers other than the area where a desired circuit pattern is to be formed.

At the next step (d), the board processed through the step (c) is set to an anode, and an alkali-soluble aninoic electrodeposit etching resist is applied by electrodeposition, over the area on the surface of the conductive metal layer from which the coating formed by the step (c) has been removed, namely the area on which the desirted circuit pattern is to be formed.

During this step (d), the area or portion on the board covered by the photoresist coating, which has been formed from the acid-soluble cationic electrodeposit photoresist, is not applied with the etching resist since substantially no electric current passes through such portion or area.

The alkali-soluble anionic electrodeposit etching resist which may be used in the step (d) is composed, for example, of a resin having a carboxylic acid group to be neutralized with an organic amine so as to become watr-soluble or water-dispersible. Any resin or resinous materials exhibiting the behavior as aforementioned may be used in the invention. Specific examples are polymers or copolymers of (meth)acrylic acid; polymers and copolymers of maleic acid or maleic anhydride, citraconic acid or citraconic anhydride and fumaric acid or fumaric anhydride, and addition products thereof; and reaction products of α,β-dicarboxylic acids, such as maleic anhydride, succinic anhydride and phthalic anhydride, with either one of alcohol or amine compounds.

More preferably, the etching resist may contain an organic polymer (IV) prepared by adding a half-ester group (G) onto at least a portion of double bonds of a main chain polymer (F) which will be described in detail in the following paragraphs et seq.

It is preferred that the main chain polymer (F) comprises a polymer having a molecular weight of from 300 to 30,000, an iodine value of from 50 to 500, preferably from 100 to 470, and having therein carbon-carbon double bonds. For example, any one or more of the compounds, which may be used as the main chain polymer (D), may also be used singly or in combination also as the polymer (F). Likewise, the main chain polymer (F) may be prepared through a similar process as employed for the preparation of the main chain polymer (D).

Examples of the half-ester group (G) include those represented by the following formula (8) of:

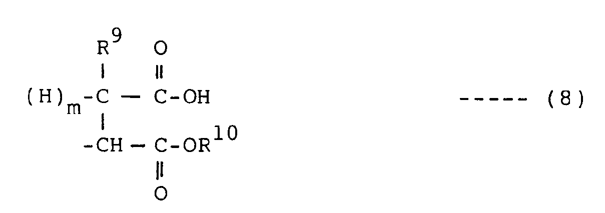

In the formula (8), R⁹ stands for a hydrogen atom, a halogen atom or an organic residue having 1 to 3 carbon atoms; R¹⁰ stands for an organic residue having 1 to 12 carbon atoms, preferably an alkyl group having 3 to 10 carbon atoms or a group represented by -Y-OR′ where R′ stands for an alkyl group having 1 to 10 carbon atoms and Y stands for an alkylene group having 2 to 3 carbon atoms; and m is 0 (zero) or 1, and when m is zero, a portion of the main chain is formed by both of the carbon atoms, one being bound to R⁹ and the other being adjacent to the one carbon atom and bound to a hydrogen atom. Meantime, it is not preferred that the groups R⁹ and/or R¹⁰ have carbon atoms out of the defined range, since it becomes difficult to prepare the compounds.

In order to add the half-ester group (G) onto at least a portion of double bonds of the main chain polymer (F), an α,β-unsaturated dicarboxylic anhydride, such as maleic anhydride, citraconic anhydride or chloromaleic anhydride, is added to the main chain polymer (F), for example, at the initial stage to introduce an acid anhydride group represented by the following formula (9) of: 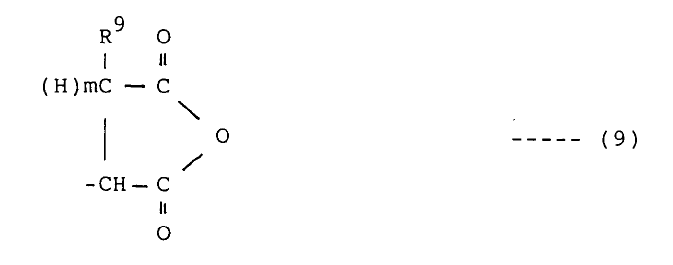
wherein R⁹ is the same as the group R⁹ of the formula (8) and m is the same as m of the formula (8).
and then the thus introduced acid anhydride group is allowed to react with a hydroxyl group-containing compound (i) represented by the following formula (10) of:

R¹⁰OH (10)

wherein R¹⁰ is the same as the group R¹⁰ in the formula (8) set forth hereinbefore;
to convert the acid anhydride group represented by the formula (9) to the half-ester group (G) represented by the formula (8).

Addition of the acid anhydride group represented by the formula (9) to the main chain polymer (F) may be effected similarly to the step of adding the acid anhydride group represented by the formula (4) to the main chain polymer (D) as aforementioned; and half-esterification by the reaction with the hydroxyl group-containing compound (i) may be effected similarly to half-esterification with the hydroxyl group-containing compound (H) as described before.

The added amount of the half-ester group (G) ranges generally from 0.05 to 1.5 mols, preferably from 0.1 to 1.2 mols, based on 100g of the main chain polymer (F). If less than 0.05 mol of the half-ester group (G) is added, it becomes difficult to dissolve or disperse the alkali-soluble anionic electrodeposit etching resist; whereas the production on industrial scale becomes difficult if more than 1.5 mols of the half-ester group (G) is added. Thus, the added amount may better be controlled within the defined range.

On the other hand, the hydroxyl group-containing compound (i), which may be used in this step, includes for example compounds which are usable also as the hydroxyl group-containing compounds (H) which has been described in detail hereinbefore. These compounds may be used singly or in combination.

The organic polymer (IV) may be prepared following the procedure described above.

Although the alkali-soluble anionic electrodeposit etching resist used in the step (d) need not be photopolymerized or thermally polymerized after it is applied by electrodeposition, a (meth)acryl or epoxy group may be introduced into the organic polymer (IV) to render the same thermally polymerizable or photopolymerizable.

In order to use the organic polymer (IV) as a main ingredient in the alkali-soluble anionic electrodeposit etching resist, the polymer (IV) may become water-soluble or water-dispersible.

As general means for the provision of water-solubility or water-dispersibility, an organic amine, such as trimethylamine, triethylamine or diemethylamine, is added in a ratio of 0.2 to 1.0 molar equvalent, based on one equivalent of the carboxylic acid group in the organic polymer (IV), to neutralize the polymer (IV). The temperature at the step for the provision of water-solubility or water-dispersibility is not particularly limited, and generally ranges within 0°C to 120°C, the temperature around room temperature being most preferred.

With the aims to facilitating solubilizing or dispersing, improving the stabilty of the aqueous solution or dispersion, and additionally effectively performing the subsequent step (e), it is preferable to add one or more of organic solvents which are water-soluble and yet can dissolve respective resinous ingredients. Specific examples of such organic solvent include ethyl cellosolve, propyl cellosolve, butyl cellosolve, ethylene glycol dimethyl ether, diethylene glycol dimethyl ether, diacetone alcohol and methyl ethyl ketone. Preferable mixing ratio of such an organic solvent ranges 10 to 100 parts by weight, based on 100 parts of the organic polymer (IV).

Any resins may be used in the etching resist, as far as they have carboxylic acid groups to be neutralized with organic amines to become water-soluble or water-dispersible. However, it is required to use those which are not tacky at room temperature in view of the convenience in operation. Such a requirement may be satisfied, for example, by introducing a polymerizable functional group, such as (meth)acryl or epoxy group, into the anionic resin constituting the etching resist, and the anionic resin having the thus introduced polymerizable functional group is heated or exposed to ultraviolet ray after it is electrodeposited. When exposure to ultraviolet ray is adopted, a photosensitive agent may be used in combination, similarly to the case of cationic electrodeposit photoresist. On the other hand, when maleic acid or maleic anhydride is used, tack may be elimanated by using a phenyl group or a polycyclic side chain group for forming the ester group. Thus, by properly selecting a side chain of the resin, tack may be lost without the need of cross-linking reaction.

Otherwise, an additive may be added to exclude tackiness of the composition. Specific examples of such an additive include waxes which are solid at ambient temperature, epoxy resins, the prepolymer (III) having photosensitive ethylenic double bonds, and known photopolymerizable monomers such as 2-ethylhexyl acrylate, 2-hydroxyethyl acrylate, 1,3-butanediol acrylate, trimethylolpropane triacrylate, pentaerythritol triacrylate, 2-ethylhexyl methacrylate, 2-hydroxyethyl methacrylate, 1,3-butanediol methacrylate, trimethylolpropane trimethacrylate, pentaerythritol trimethacrylate and tri(acryloyloxyethyl) isocyanurate having a high melting point. These additives may be used singly or in combination.

In application, by electrodeposition, of the thus prepared alkali-soluble anionic electrodeposit etching resist on the area or portion of the conductive metal layer, the area being uncoated with the cured photoresist, an aqueous solution or dispersion of the etching resist is prepared, and the board treated and fed through the step (c) is dipped in the solution or dispersion while setting the board as the anode, followed by supplying direct current to deposite the alkali-soluble anionic electrodeposit etching resist at the portion or area, which corresponds to the circuit pattern to be formed, of the conductive metal layer. It is preferred that the thickness of the etching resist ranges normally from 5 to 20 »m.

The electrodeposited alkali-soluble anionic electrodeposit etching resist applied by the step (d) is then heated at a temperature of from 50°C to 120°C to remove the solvent from the electrodeposited coating and to flow the resist material to avoid pinholes to obtain a uniform film.

When it is needed to cure the electrodeposited film by exposure to ultraviolet ray or heating, ultraviolet ray is irradiated from a high pressure mercury lamp, an ultra-high pressure mercury lamp, a xenon lamp or a metal halide lamp, or heating is effected in an electric furnace.

Through the succesive treating steps (a) to (e), to the surface of the conductive metal layer of the board there is applied the coating of the alkali-soluble anionic electrodeposit etching resist at the area or portion corresponding to the circuit pattern, and the cured coating formed of the acid-soluble cationic electrodeposit photoresist at the area or portion other than the circuit pattern.

At the next step (f), the cured coating of the acid-soluble cationic electrodeposit photoresist covering the area other than the circuit pattern is removed with an aqueous acid solution.

In general, a 1 to 10 wt% aqueous solution of hydrochloric acid or sulfuric acid may be preferably used as the acid solution for this purpose, and an aqueous solution of an organic acid, such as acetic acid, propionic acid or lactic acid, may also be used as long as the temperature thereof is maintained at a temperature of from 30°C to 100°C.

Although the condition at the step (f) is varied depending on the thickness of the coating of the resultant acid-soluble cationic electrodeposit photoresist, and also on the comosition and concentration of the used aqueous acid solution, it is preferred that the temperature ranges generally from 0°C to 70°C, preferably from 10°C to 60°C, and the time required for removal of the photoresist ranges generally from about 30 seconds to about 10 minutes. Most preferably, the temperature is higher than that in the step (c) and/or the treating duration time is longer than that in the step (c). By selecting proper conditions for respective steps, the same aqueous solution of the same acid, as used as the developer in the step (c) may be used as a stripper in this step (f).

After treating through the step (f), the coating of the alkali-soluble anionic electrodeposit etching resist is left to cover the circuit pattern on the conductive metal layer of the board.

At the subsequent step (g), the portion of the conductive metal layer exposed by the preceding step (f) is etched to form a circuit arrangement. Etching of the conductive metal layer at the portion other than the circuit pattern may be dissolved and removed using any of known etching agent, such as ferric chloride, cupric chloride, ammonium persulfate and chlorocapric acid, or a combination of hydrogen peroxide and phosphoric acid.

Conditions for etching are varied depending on the specific kind and thickness of the metal used for forming the conductive metal layer and also depending on the used etching solution. For example, when ferric chloride or cupric chloride is used, the concentration ranges normally from 20 to 60 wt%, the temperature ranges normally from 10°C to 80°C, preferably from room temperature to 60°C, and the treating time ranges normally from about 30 seconds to about 10 minutes.

At the final step (h), the film of the alkali-soluble anionic electrodeposit etching resist left to cover the circuit pattern is removed, using an aqueous alkali solution.

The etching resist film may be removed by spraying an aqueous alkali solution, or alternatively by dipping the board in an aqueous alkali solution.

Examples of aqueous alkali solution, which may be used as a stripper to remove the etching resist at this step (h), include a 1 to 3 wt% aqueous solution of sodium carbonate and sodium hydroxide. A proper surface active agent or a water-soluble solvent may be added.

After treating succesively through the steps (a) to (h), a through-hole printed circuit board can be prepared.

By the practice of the present invention, a through-hole printed circuit board having very small through-holes and via-holes each having inner wall plated with an electrically condutive metal layer or layers and having surfaces formed with very fine circuit patterns, can be prepared stably and easily on an industrial scale.

In the through-hole printed circuit board prepared in accordance with the invention, very fine circuit patterns can be arranged such that more than eight lines extend between adjacent pins, while ensuring safe preservation of electrically conductive metal layers applied on the inner walls of respective via-holes each having so small diameter of in the order of 100»m or so.

The present invention has an additional merit that the operator can perform the operation in good environment, since no solvent is used for the removal of photoresist and etching resist coatings.

### EXAMPLES OF THE INVENTION:

The present invention will be described more specifically with reference to examples thereof. However, it is to be noted hereby that the invention should not be limited to the following examples.

### Preparation Example 1

NISSEKI Polybutadiene B-1800 (Trade Name; Produced by Nippon Oil Co., Ltd.; Number Average Molecular Weight: 1800; 1,2-Bond: 64%) was epoxidated, using peracetic acid to prepare an epoxidated polybutadiene having an oxyranic oxygen content of 6.5 wt%.

1,000g of the epoxydated polybutadiene and 376g of ethyl cellosolve were charged in a 2 liter autoclave, and then 62.1g of dimethylamine was added to the reaction system, which was reacted at 150°C for 5 hours.

After removing unreacted amine by distillation, the reaction mixture was cooled to 120°C. 79.3g of acrylic acid, 7.6g of hydroquinone and 26.4g of ethyl cellosolve were admixed to the reaction mixture, and the admixture was reacted at 120°C for 4 hours to obtain a solution of acryl group-containing cationic resin (I-1). The thus obtained resin had an amine value of 85.2 millimols/100g, and a solid content concentration of 75.0 wt%.

### Preparation Example 2

1,000g of NISSEKI Polybutadiene B-1000 (Trade Name; Produced by Nippon Oil Co., Ltd.; Number Average Molecular Weight: 1000; Iodine Value: 430; 1,2-Bond: 65%), 554g of maleic anhydride, 10g of xylene and 5.0g of Antigen (Trade Name; Polymerization inhibitor produced by Sumitomo Chemical Co., Ltd.) were charged into a 3 liter separable flask provided with a reflux cooling tube and a nitrogen blow-in tube. The content in the flask was reacted at 190°C for 5 hours under a nitrogen stream. Then, unreacted maleic acid and unreacted xylene were distilled off to obtain a maleinated butadiene polymer having a total acid value of 400 mgKOH/g. The softening point of the resultant polymer (softening point determined by the ring and ball test as stipulated in JIS-K-2531-60) was 88°C.

Into a 3 liter separable flask provided with a reflux cooling tube, charged were 1,000g of the maleinated polybutadiene and 433g of butyl cellosolve to dissolve the former in the latter uniformly. The reaction mixture was heated to 135°C under flowing nitrogen, and 364.4g of N,N-dimethylaminopropylamine was dropwise added over a period of an hour while maintaining the reaction temperature at 135°C.

The reaction was continued for additional 5 hours while maintaining the temperature of the reaction mixture at 135°C to obtain a solution of a polyamine (II-1) containing tertiary amine and imide groups.

The thus prepared polyamine (II-1) had a content of non-volatile matter of 75 wt%, and contained 206 millimols of tertiary amine per 100g of the solution.

### Preparation Example 3

Into a 3 liter separable flask provided with a reflux cooling tube, charged were 1,000g of the maleinated polybutadiene synthesized in Preparation Example 2 and having a total acid value of 400 mgKOH/g, 192.3g of benzyl alcohol, 210.7g of butyl cellosolve and 3g of dimethylbenzylamine. The content in the flask was heated to 90°C under flowing nitrogen, followed by stirring for 1.5 hours while maintaining the reaction temperature at 90°C, and then 468g of ethyl cellosolve was added to obtain a solution of a half-esterified product (IV-1). The thus obtained solution of half-esterified product contained a non-volatile content of 75 wt% and a total acid value of 107 mgKOH/g.

### Preparation Example 4

Into a 2 liter separable flask provided with a reflux cooling tube, 1,000g of Epikote 1004 (Trade Name, Bisphenol-A type epoxy resin produced by Yuka Shell Epoxy K.K. and having an epoxy equivalent of 920), 353g of ethyl cellosolve and 4.0g of hydroquinone were changed. After dissolving the mixture uniformly at 100°C, 90g of methacrylic acid and 6g of N,N-dimethylaminoethanol were dropwise added over a period of 30 minutes. After the completion of dropwise addition, the reaction was allowed to proceed at 120°C for 3 hours to obtain a solution of epoxy methacrylate (III-1). The thus obtained solution of epoxy methacrylate has a non-volatile content of 75 wt%.

### Preparation Example 5

Into a 3 liter separable flask provided with a reflux cooling tube, charged was 1090g of YDCN-702 (Trade Name; Cresol novolak type epoxy resin produced by Toto Kasei K.K. and having an epoxy equivalent of 218), which was heated to 90°C to be melted. Then, 490g of ethyl cellosolve, 396g of acrylic acid, 4.0g of hydroquinone and 7.0g of dimethylbenzylamine were dropwise added, followed by stirring at 110°C for 12 hours, whereby an epoxy acrylate (III-2) having a solid content concentration of 75 wt% was obtained.

### Preparation Example 6

After mixing 100g of a solution of the acryl group-containing cationic resin (I-1) prepared by Preparation Example 1 and having a solid content concentration of 75.0 wt%, 5g of trimethylolpropane triacrylate, 8g of Ingacure 651 (Trade Name; Photopolymerization initiator produced by Ciba-Geigy AG) and 11g of ethyl cellosolve, followed by stirring until a uniform mixture was formed, 2.6g of acetic acid was added under sufficient stirring to neutralize the mixture. Then, deionized water was added slowly to obtain an aqueous solution (1) of an acid-soluble cationic electrodeposit photoresist having a solid content concentration of 15 wt%.

### Preparation Example 7

After mixing 60g of a solution of polyamine (II-1) produced by Preparation Example 2 and having a solid content concentration of 75.0 wt%, 40g of the solution of epoxy methacrylate (III-1) prepared by Preparation Example 4, 15g of trimethylolpropane triacrylate, 8g of Ingacure 651 (Trade Name; Photopolymerization initiator produced by Ciba-Geigy AG) and 23g of ethyl cellosolve until a uniform mixture was obtained, 3.7g of acetic acid was added and stirred sufficiently to neutralize the mixture. Then, deionized water was added slowly to obtain an aqueous solution (2) of an acid-soluble cationic electrodeposit photoresist having a solid content concentration of 15 wt%.

### Preparation Example 8

After mixing 58g of the solution of polyamine (II-1) produced by Preparation Example 2 and having a solid content concentration of 75.0 wt%, 42g of the solution of epoxy acrylate (III-2) prepared by Preparation Example 5, 5g of pentaerythritol triacrylate, 8g of Ingacure 907 (Trade Name; Photopolymerization initiator produced by Ciba-Geigy AG) and 13g of ethyl cellosolve until a uniform mixture was obtained, 3.7g of acetic acid was added and stirred sufficiently to neutrlize the mixture. Thereafter, deionized water was added slowly to obtain an aqueous solution (3) of an acid-soluble cationic electrodeposit photoresist having a solid content concentration of 15 wt%.

### Preparation Example 9

To 100g of the solution of half-esterified product of maleinated polybutadiene (IV-1) produced by Preparation Example 3 and having a solid content concentration of 75.0 wt% was added 9.6g of triethylamine, followed by stirring sufficiently to neutralize the half-esterified product of maleinated polybutadiene. Then, deionized water was added slowly to obtain an aqueous solution (4) of an alkali-soluble anionic electrodeposit etching resist having a solid content concentration of 15 wt%.

### Example 1

A glass-epoxy dual-side copper-clad laminate was pierced with through-holes at pre-set positions, and then the overall surfaces including the inner walls of the through-holes were plated with copper by non-electrolytic plating and subsequent electrolytic plating. The laminate was set to the cathode and a stainless steel plate was set to the anode. The cathode and the anode were dipped in an electrodeposition vessel containing therein the aqueous solution (1) of the acid-soluble cationic electrodeposit photoresist produced by Preparation Example 6 and having a solid content concentration of 15 wt%, the temerature of the liquid in the vessel being maintained at 28°C, and direct current was applied at a current density of 50 mA/dm² for 2 minutes.

After washing with water, the laminate was heated at 80°C for 20 minutes, followed by cooling, to form a uniform pinhole-free coating having a thickness of about 10 »m.

A photo-mask having a pattern complementary to the circuit pattern to be formed was closely placed on the laminate on which the acid-soluble cationic electrodeposit photoresist was uniformly coated, and ultraviolet ray having a wavelength of 365 nm and an exposure amount of 150 mJ/cm² was irradiated, using a UV exposure apparatus ("High Pressure Mercury Lamp Irradiator UVL-2518" produced by USHIO Inc.). After being exposed to the ultraviolet ray, the coating was developed with a 1.5 wt% aqueous solution of lactic acid, and then rinsed with water to form a cured photoresist film forming the reverse pattern.

Then, the laminate coated with the cured: film of the cationic electrodeposit photoresist, which formed the reverse pattern, was set to the anode and a stainless steel plate was set to the cathode. The anode and the cathode were dipped in an electrodeposition vessel in which contained was the aqueous solution (4) of alkali-soluble anionic electrodeposit etching resist prepared by Preparation Example 9 and having a solid content concentration of 15 wt%, the temperature of the liquid in the vessel being maintained at 30°C, and direct current was applied at a current density of 50 mA/dm² for 1.5 minutes.

After washing with water, the laminate was heated at 80°C for 20 minutes and then cooled, whereby the reverse pattern was covered by the cationic electrodeposit photoresist layer and the pattern corresponding to the circuit pattern to be formed was covered by the anionic electrodeposit etching resist, both coatings being free of pinholes and each having a thickness of 10 »m.

The laminate was dipped in a 2 wt% dilute sulfuric acid bath maintained at 30°C for 1 minute, whereby only the acid-soluble cationic electrodeposit photoresist layer was removed and the pattern corresponding to the circuit pattern to be formed was covered by the alkali-soluble anionic electrodeposit etching resist.

The board now having the anionic electrodeposit etching resist covering only the circuit pattern and the through-holes to be left was dipped in a 30 wt% ferric chloride etching bath maintained at 30°C for 3 minutes under stirring, and then washed with water to form a circuit pattern.

The etched board was dipped in a 1 wt% aqueous solution of sodium carbonate to remove the etching resist layer, and then washed with water and dried to produce a desired through-hole printed circuit board.

The lines of the thus formed circuit is free of defect, even for a line having a width of 50»m. The copper plating on the inner walls of the through-holes was not corroded by the etching solution, and the copper plating was preserved in good condition equivalent to the plating on the surface of the virgin laminate before use.

### Example 2

A glass-epoxy dual-side copper-clad laminate applied with copper plating all over on the surfaces including the inner walls of through-holes was set to the cathode, and a stainless steel plate was set to the anode, and the cathode and the anode were dipped in an electrodeposition vessel containing the aqueous solution (2) of acid-soluble cationic electrodeposit photoresist produced by Preparation Example 7 and having a solid content concentration of 15 wt% while maintaining the temperature of the liquid at 28°C. Direct current was applied at a current density of 60 mA/dm² for 2 minutes.

After washing with water, the laminate was heated at 80°C for 10 minutes and cooled to form a uniform 9 »m thick coating, the coating being free of tack and free of pinholes at ambient temperature.

A photo-mask having a pattern reverse to the pattern of the circuit to be formed was closely fitted on the laminate in vacuum, and ultraviolet ray having a wavelength of 365 nm and an exposure amount of 100 mJ/cm² was irradiated in the same UV exposure apparatus as used in Example 1. After being exposed to ultraviolet ray, the coating was developed with a 1.5 wt% aqueous solution of acetic acid and then rinsed with water to form a cured photoresist film having the reverse pattern.

The laminate having the reverse pattern of the cationic electrodeposit photoresist was set to the anode, and a stainless steel plate was set to the cathode. The anode and the cathode were dipped in an electrodeposition vessel containing the aqueous solution (4) of alkali-soluble anionic electrodeposit etching resist prepared by the Preparation Example 9 and maintained at 25°C, and then direct current was applied at a current density of 50 mA/dm² for 2 minutes.

After the completion of electrodeposition, the laminate was heated at 80°C for 10 minutes and then cooled so that the reverse pattern was covered by the cationic electrodeposit photoresist layer and the pattern to be formed was covered by the anionic electrodeposit etching resist layer, the both layers being free of pinholes and having a thickness, of 10 »m.

The laminate was dipped in a 2 wt% dilute sulfuric acid bath maintained at 35°C to prepare a board on which only the area corresponding to the circuit pattern to be formed was covered by the alkali-soluble anionic electrodeposit etching resist.

The board was dipped in a 30 wt% ferric chloride bath maintained at 30°C for 2 minutes, and then washed with water to form a circuit pattern.

The thus etched board was dipped in a 1 wt% solution of sodium carbonate to remove the etching resist layer, and then washed with water and dried to produce a desired through-hole printed circuit board.

The lines of the thus formed circuit is free of defect, even for a line having a width of 30 »m. The copper plating was preserved in good condition equivalent to the plating on the surface of the laminate.

### Example 3

A glass-epoxy dual-side copper-clad laminate was pierced with through-holes at pre-set positions, and then the overall surfaces including the inner walls of the through-holes were plated with copper by non-electrolytic plating and subsequent electrolytic plating. The laminate was set to the cathode and a stainless steel plate was set to the anode. The cathode and the anode were dipped in an electrodeposition vessel containing therein the aqueous solution (3) of acid-soluble cationic electrodeposit photoresist produced by Preparation Example 8 and having a solid content concentration of 15 wt%, the temerature of the liquid in the vessel being maintained at 28°C, and direct current was applied at a current density of 50 mA/dm² for 2 minutes.

After washing with water, the laminate was heated at 80°C for 20 minutes, followed by cooling, to form a uniform pinhole-free coating having a thickness of 9.5 »m.

A photo-mask having a pattern complementary to the circuit pattern to be formed was closely placed in vacuum on the laminate on which the acid-soluble cationic electrodeposit photoresist was uniformly coated, and ultraviolet ray having a wavelength of 365 nm and an exposure amount of 150 mJ/cm² was irradiated, using the same UV exposure apparatus as used in Example 1. After being exposed to ultraviolet ray, the coating was developed with a 1.5 wt% aqueous solution of lactic acid, and then rinsed with water to form a cured photoresist film forming the reverse pattern.

Then, the laminate coated with the cured film of the cationic electrodeposit photoresist, which formed the reverse pattern, was set to the anode and a stainless steel plate was set to the cathode. The anode and the cathode were dipped in an electrodeposition vessel in which contained was the aqueous solution (4) of alkali-soluble anionic electrodeposit etching resist prepared by Preparation Example 9 and having a solid content concentration of 15 wt%, the temperature of the liquid in the vessel being maintained at 30°C, and direct current was applied at a current density of 50 mA/dm² for 1.5 minutes.

After washing with water, the laminate was heated at 80°C for 20 minutes and then cooled, whereby the reverse pattern was covered by the cationic electrodeposit photoresist layer and the pattern corresponding to the circuit pattern to be formed was covered by the anionic electrodeposit etching resist, both coatings being free of pinholes and each having a thickness of about 10 »m.

The laminate was dipped in a 2 wt% dilute sulfuric acid bath maintained at 30°C for 1 minute, whereby only the acid-soluble cationic electrodeposit photoresist layer was removed and the pattern corresponding to the circuit pattern to be formed was covered by the alkali-soluble anionic electrodeposit etching resist.

The board now having the anionic electrodeposit etching resist covering only the circuit pattern and the through-holes to be left was dipped in a 30 wt% ferric chloride etching bath maintained at 30°C for 3 minutes under stirring, and then washed with water to form a circuit pattern.

The etched board was dipped in a 1 wt% aqueous solution of sodium carbonate to remove the etching resist layer, and then washed with water and dried to produce a desired through-hole printed circuit board.

The lines of the thus formed circuit is free of defect, even for a line having a width of 30»m. The copper plating on the inner walls of the through-holes was not corroded by the etching solution, and the copper plating was preserved in good condition equivalent to the plating on the surface of the virgin laminate before use.

## Claims

1. A process for preparing a through-hole printed circuit board having at least one through-hole, comprising the steps of:
(a) applying an acid-soluble cationic electrodeposit photoresist by electrodeposition all over on a surface of a board covered by an electrically conductive metal layer including said through-hole, while setting said board as a cathode;
(b) heating the board passed through the step (a) to a tempeature of from 50°C to 120°C;
(c) exposing of said acid-soluble cationic electrodeposit photoresist to light through a photo-mask having a pattern complementary to a pattern of a circuit to be formed on the board, thereby to cure the photoresist, and then developing with a developer to remove only an uncured portion of said photoresist;
(d) applying an alkali-soluble anionic electrodeposit etching resist by electrodeposition on a surface of a portion of said electrically conductive metal layer uncoated with the cured photoresist, while setting said board passed through the step (c) as an anode;
(e) heating the board passed through the step (d) to a temperature of from 50 to 120°C;
(f) removing a coating of said cured acid-soluble cationic electrodeposit photoresist with an aqueous acid solution;
(g) etching a portion of said electrically conductive metal layer exposed by the preceding step (f); and
(h) removing the remaining alkali-soluble anionic electrodeposit etching resist with an aqueous alkali solution.

2. The process according to claim 1, wherein said acid-soluble cationic electrodeposit photoresist is selected from the group consisting of a photoresist containing therein a resin having amino and (meth)acryl groups, a photoresist containing therein a resin having an amino group and a photosensitive prepolymer, and mixtures thereof.

3. The process according to claim 2, wherein said photoresist containing therein a resin having amino and (meth)acryl groups is a photoresist comprising a (meth)acryl group-containing cationic resin (I) and a photo polymerization initiator, said (meth)acryl group-containing cationic resin (I) being prepared by reacting a polymer (A) having a molecular weight of from 500 to 5,000, an iodine value of from 50 to 500, a carbon-carbon double bond and 3 to 12 wt% of oxyranic oxygen with an amine compound (B) represented by the following formula (1) of: 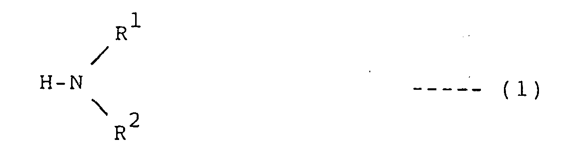 wherein R¹ and R² may be the same or different group and each stands for an organic residue having 1 to 20 carbon atoms or an organic residue having 1 to 20 carbon atoms and having a portion thereof substituted by a hydroxyl group, with or without a ring-structure being formed by said groups R¹ and R² and with or without an unsaturated group present in said ring-structure;
and then further reacting with an α,β-unsaturated carboxylic acid (C) represented by the following formula (2) of: 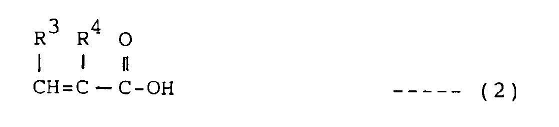 wherein R³ and R⁴ may be the same or different group and each stands for a hydrogen atom or a methyl group.

4. The process according to claim 3, wherein said polymer (A) is a polymer prepared by epoxidizing a starting organic polymer having a molecular weight of from 500 to 5,000, an iodine value of from 50 to 500 and having a carbon-cabon double bond with the use of a peroxide selected from the group consisting of hydrogen peroxide, performic acid, peracetaic acid, m-chloroperbenzoic acid and mixtures thereof to introduce said oxyranic oxygen in an amount of from 3 to 12 wt% as calculated as oxygen, said starting organic polymer being prepared by an anionic polymerization of a monomer selected from the group consisting of conjugated diolefins each having 4 to 10 carbon atoms, mixtures of one or more conjugated diolefins each having 4 to 10 carbon atoms and mixtures of one or more of said conjugated diolefins with not more than 50 mol% of aromatic vinyl monomers, and said anionic polymerization being effected at a temperature range of from 0°C to 100°C in the presence of a catalyst selected from the group consisting of alkali metals, organic compounds of alkali metals and mixtures thereof.

5. The process according to claim 2, wherein said photoresist containing therein a resin having an amino group and a photosensitive prepolymer, comprises a polyamine (II) having a group (E) represented by the following formula (3) of: 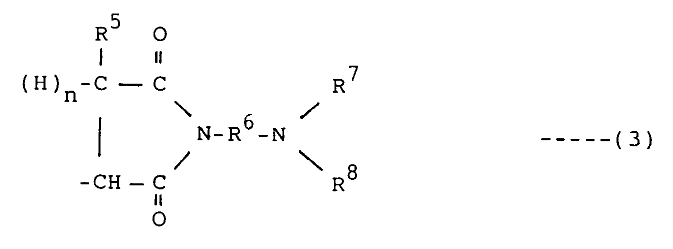 wherein R⁵ stands for a hydrogen atom, a halogen atom or an organic residue having 1 to 3 carbon atoms; R⁶ stand for an alkylene or arylene chain having 1 to 10 carbon atoms; R⁷ and R⁸ may be the same or different group and each stands for an organic residue having 1 to 3 carbon atoms; and n is 0 (zero) or 1 and when n is zero, a portion of the main chain is formed by both of the carbon atoms, one being bound to R⁵ and the other being adjacent to said one carbon atom and bound to a hydrogen atom;
said group (E) being introduced at least at a portion of a double bond of a main chain polymer (D) having a molecular weight of from 300 to 30,000 and an iodine value of from 50 to 500 and including carbon-carbon double bonds; a photosensitive prepolymer (III) having an ethylenic double bond; and a photopolymerization initiator.

6. The process according to claim 5, wherein said main chain polymer (D) is selected from the group consisting of natural oils and fats, stand oils, oligomers of conjugated diolefins, copolymers of said conjugated diolefins having low degree of polymerization copolymerized with vinyl monomers each having an ethylenically unsaturated group, petroleum resins, copolymers of butadiene/isobutylene having low degree of polymerization, and mixtures thereof.

7. The process according to claim 5, wherein said polyamine (II) is prepared by the steps of adding an α,β-unsaturated dicarboxylic anhydride selected from the group consisting of maleic anhydride, citraconic anhydride, chloromaleic anhydride and mixtures thereof to said main chain polymer (D); introducing an acid anhydride group represented by the following formula (4) of: 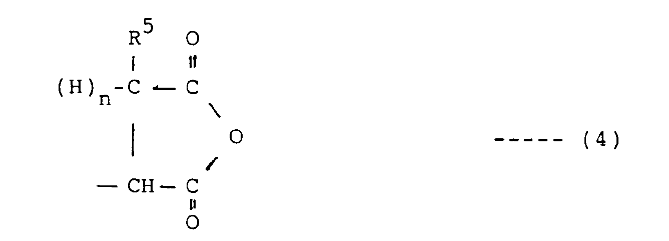 wherein R⁵ stands for a hydrogen atom, a halogen atom or an organic residue having 1 to 3 carbon atoms; and n is 0 (zero) or 1 and when n is zero, a portion of the main chain is formed by both of the carbon atoms, one being bound to R⁵ and the other being adjacent to said one carbon atom and bound to a hydrogen atom;
; reacting then with a hydroxyl group-containing compound (H) represented by the following formula (5) of:
R¹¹OH (5)
wherein R¹¹ is an organic residue having 1 to 12 carbon atoms, or -Y′-OR˝, where R˝ is an alkyl group having 1 to 10 carbon atoms and Y′ is an alkylene group having 2 to 3 carbon atoms;
to convert the acid anhydride group represented by the formula (4) to a half-ester group represented by the following formula (6) of: 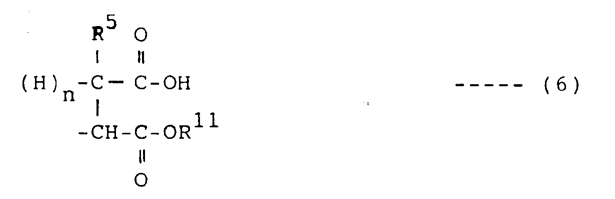 wherein R⁵, R¹¹ and n are the same as defined in the formula (4) for R⁵ and n, and the same as defined in the formula (5) for R¹¹;
and thereafter reacting with a diamine compound represented by the formula (7) of: 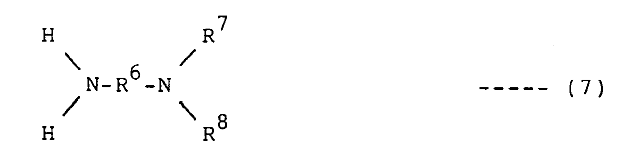 wherein R⁶ is an alkylene or arylene chain having 1 to 10 carbon atoms; and R⁷ and R⁸ are the same or different group and each stands for an organic residue having 1 to 3 carbon atoms.

8. The process according to claim 1, wherein said alkali-soluble anionic electrodeposit etching resist comprises an organic polymer (IV) which is an addition product of a main chain polymer (F) having a molecular weight of from 300 to 30,000 and an iodine value of from 50 to 500 and having double bonds, a half-ester group (G) being added at least at a portion of said double bonds, said half-ester group (G) being represented by the following formula (8) of: 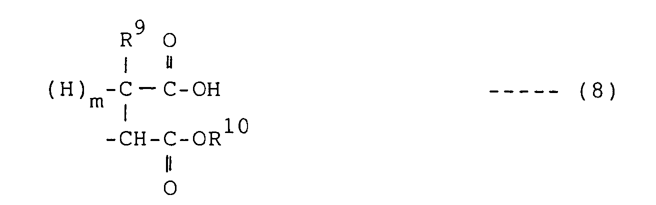 wherein R⁹ stands for a hydrogen atom, a halogen atom or an organic residue having 1 to 3 carbon atoms; R¹⁰ stands for an organic residue having 1 to 12 carbon atoms or a group represented by -Y-OR′ where R′ stands for an alkyl group having 1 to 10 carbon atoms and Y stands for an alkylene group having 2 to 3 carbon atoms; and m is 0 (zero) or 1 and when m is zero, a portion of the main chain is formed by both of carbon atoms, one being bound to R⁹ and the other being adjacent to said one carbon atom and bound to a hydrogen atom.

9. The process according to claim 8, wherein said main chain polymer (F) is selected from the group consisting of natural oils and fats, stand oils, oligomers of conjugated diolefins, copolymers of said conjugated diolefins having low degree of polymerization copolymerized with vinyl monomers each having an ethylenically unsaturated group, petroleum resins, copolymers of butadiene/isobutylene having low degree of polymerization, and mixtures thereof.

10. The process according to claim 8, comprising the step of adding an α,β-unsaturated dicarboxylic anhydride selected from the group consisting of maleic anhydride, citraconic anhydride, chloromaleic anhydride and mixtures thereof to said main chain polymer (F) to introduce an acid anhydride group represented by the following formula (9) of: 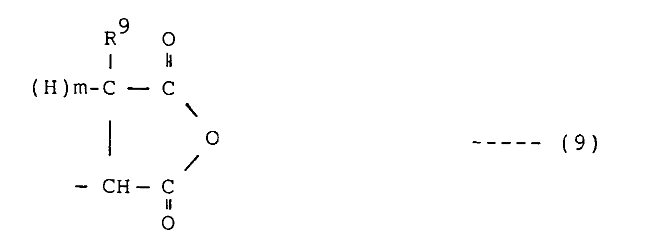 wherein R⁹ stands for R⁹ in said formula (8); and
m stands for m in said formula (8).
; reacting then with a hydroxyl group-containing compound (i) represented by the following formula (10) of:
R¹⁰OH (10)
wherein R¹⁰ stands for R¹⁰ in said formula (8); to convert the acid anhydride group represented by the formula (9) to said half-ester group (G).

## Patentansprüche

1. Verfahren zur Herstellung einer mit Durchgangslöchern versehenen Printplatte, die mindestens ein Durchgangsloch aufweist, mit den folgenden Schritten:
(a) Aufbringen eines säurelöslichen kationischen Galvano-Photoresistes durch galvanisches Abscheiden über die gesamte Fläche einer Platte, die von einer elektrisch leitenden Metallschicht bedeckt ist und das Durchgangsloch aufweist, während die Platte als Kathode geschaltet wird;
(b) Erhitzen der nach Schritt (a) behandelten Platte auf eine Temperatur von 50°C bis 120°C;
(c) Belichten des säurelöslichen kationischen Galvano-Photoresistes durch eine Photomaske, die ein Muster aufweist, das zu dem Muster einer auf der Platte auszubildenden Schaltung komplementär ist, um auf diese Weise den Photoresist auszuhärten, und dann Entwicklen mit einem Entwickler, um nur einen nicht ausgehärteten Abschnitt des Photoresistes zu entfernen;
(d) Aufbringen eines alkalilöslichen anionischen Galvano-Ätzresistes durch galvanisches Abscheiden auf einer Fläche eines Abschnittes der elektrisch leitenden Metallschicht, der nicht mit dem ausgehärteten Photoresist bedeckt ist, während die der Behandlung nach Schritt (c) unterzogene Platte als Anode geschaltet wird;
(e) Erhitzen der gemäß Schritt (d) behandelten Platte auf eine Temperatur von 50 bis 120°C;
(f) Entfernen eines Überzuges des ausgehärteten säurelöslichen kationischen Galvano-Photoresistes mit einer wässrigen Säurelösung;
(g) Wegätzen eines Abschnittes der elektrisch leitenden Metallschicht, die gemäß dem vorhergehenden Schritt (f) behandelt wurde; und
(h) Entfernen des verbleibenden alkalilöslichen anionischen Galvano-Ätzresistes mit einer wässrigen Alkalilösung.

2. Verfahren nach Anspruch 1, bei dem der säurelösliche kationische Galvano-Photoresist aus der Gruppe ausgewählt wird, die aus den folgenden Bestandteilen besteht: einem Photoresist, der ein Harz mit Amino- und (Meth)acryl-Gruppen aufweist, einem Photoresist, der ein Harz mit einer Aminogruppe und einem lichtempfindlichen Vorpolymer enthält, und Gemischen davon.

3. Verfahren nach Anspruch 2, bei dem der Photoresist, der ein Harz mit Amino- und (Meth)acryl-Gruppen enthält, ein Photoresist ist, der ein (Meth)acryl-Gruppen-enthaltendes kationisches Harz (I) und einen Photopolymerisationsinitiator umfaßt, wobei das (Meth)acryl-Gruppen enthaltende kationische Harz (I) hergestellt wird, indem man ein Polymer (A) mit einem Molekulargewicht von 500 bis 5.000, einem Jodwert von 50 bis 500, einer C-C-Doppelbindung und 3 bis 12 Gew.% von oxyranischem Sauerstoff mit einer Aminverbindung (B), die durch die folgende Formel (1) gekennzeichnet ist: 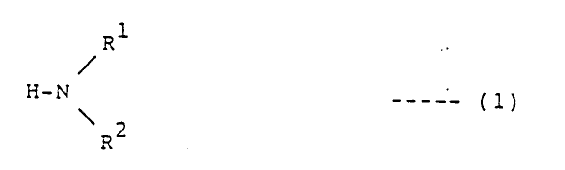 worin R¹ und R² aus der gleichen Gruppe oder verschiedenen Gruppen bestehen können und jeweils einen organischen Rest mit 1 - 20 C-Atomen oder einen organischen Rest mit 1 20 C-Atomen, wobei ein Teil davon durch eine Hydroxylgruppe substituiert ist, mit einer oder ohne eine Ringstruktur, die durch die Gruppen R¹ und und R² gebildet wird, und mit einer oder ohne eine ungesättigte Gruppe, die in der Ringstruktur vorhanden ist, bedeuten,
reagieren läßt und dann eine weitere Reaktion mit einer α,β-ungesättigten Carbonsäure (C) durchführt, die durch die folgende Formel (2) gekennzeichnet ist: 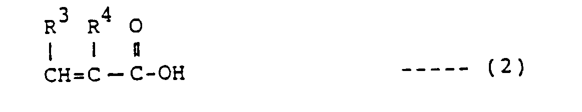 worin R³ und R⁴ aus der gleichen Gruppe oder verschiedenen Gruppen bestehen können und jeweils ein Wasserstoffatom oder eine Methylgruppe bedeuten.

4. Verfahren nach Anspruch 3, bei dem das Polymer (A) ein Polymer ist, das durch Epoxidieren eines organischen Ausgangspolymers mit einem Molekulargewicht von 500 bis 5.000, einem Jodwert von 50 bis 500 und einer C-C-Doppelbindung unter Verwendung eines Peroxides, das aus der Gruppe ausgewählt ist, die aus Wasserstoffperoxid, Perameisensäure, Peressigsäure, m-Chloroperbenzoesäure und Gemischen davon besteht, um den oxyranischen Sauerstoff in einer Menge von 3 bis 12 Gew.%, berechnet als Sauerstoff, einzuführen, hergestellt wurde, wobei das organische Ausgangspolymer durch eine anionische Polymerisation eines Monomers hergestellt wurde, das aus der Gruppe ausgewählt ist, die aus konjugierten Diolefinen, die jeweils 4 bis 10 C-Atome aufweisen, Gemischen von einem oder mehreren konjugierten Diolefinen, die jeweils 4 bis 10 C-Atome aufweisen, und Gemischen von einem oder mehreren der konjugierten Dioelfine mit nicht mehr als 50 Mol% von aromatischen Vinylmonomeren besteht, und wobei die anionische Polymerisation in einem Temperaturbereich von 0°C bis 100°C in der Gegenwart eines Katalysators durchgeführt wurde, der aus der Gruppe ausgewählt ist, die aus Alkalimetallen, organischen Verbindungen von Alkalimetallen und Gemischen davon besteht.

5. Verfahren nach Anspruch 2, bei dem der Photoresist, der ein Harz mit einer Aminogruppe und einem lichtempfindlichen Vorpolymer enthält, die folgenden Bestandteile umfaßt:
ein Polyamin (II) mit einer Gruppe (E), die durch die nachfolgende Formel (3) gekennzeichnet ist: 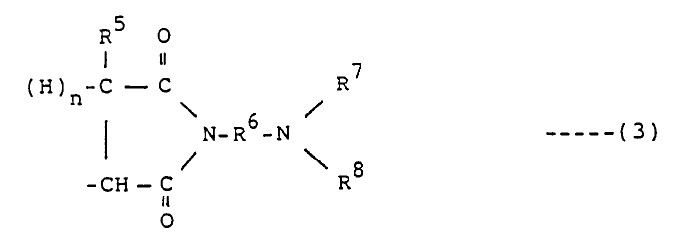 worin R⁵ ein Wasserstoffatom, ein Halogenatom oder einen organischen Rest mit 1 bis 3 C-Atomen bedeutet, R⁶ eine Alkylen- oder Arylen-Kette mit 1 bis 10 C-Atomen bedeutet, R⁷ und R⁸ aus der gleichen Gruppe oder unterschiedlichen Gruppen bestehen können und jeweils einen organischen Rest mit 1 bis 3 C-Atomen bedeuten und n 0 oder 1 ist, wobei dann, wenn n 0 ist, ein Teil der Hauptkette durch beide C-Atome gebildet ist, von denen eines an R⁵ gebunden ist und das andere benachbart zu dem einen C-Atom angeordnet und an ein Wasserstoffatom gebunden ist;
wobei die Gruppe (E) zumindest an einem Teil einer Doppelbindung eines Hauptkettenpolymers (D) mit einem Molekulargewicht von 300 bis 30.000 und einem Jodwert von 50 bis 500 und C-C-Doppelbindungen eingeführt wird;
ein lichtempfindliches Vorpolymer (III) mit einer ethylenischen Doppelbindung;
und einen Photopolymerisationsinitiator.

6. Verfahren nach Anspruch 5, bei dem das Hauptkettenpolymer (D) aus der Gruppe ausgewählt wird, die aus natürlichen Ölen und Fetten, Dickölen, Oligomeren von konjugierten Diolefinen, Copolymeren von diesen konjugierten Dioelfinen mit einem niedrigen Polymerisationsgrad, die mit Vinylmonomeren vorpolymerisiert sind, welche jeweils eine ethylenisch ungesättigte Gruppe aufweisen, Petroleumharzen, Copolymeren von Butadien/Isobutylen mit einem niedrigen Polymerisationsgrad und Gemischen davon besteht.

7. Verfahren nach Anspruch 5, bei dem das Polyamin (II) durch die folgenden Schritte hergestellt wird: Zusetzen eines α,β-ungesättigten Dicarbonsäureanhydrides, das aus der Gruppe ausgewählt ist, die aus Maleinsäureanhydrid, Citraconsäureanhydrid, Chloromaleinsäureanhydrid und Gemischen davon besteht, zum Hauptkettenpolymer (D); Einführen einer Säureanhydridgruppe, die durch die folgende Formel (4) gekennzeichnet ist: 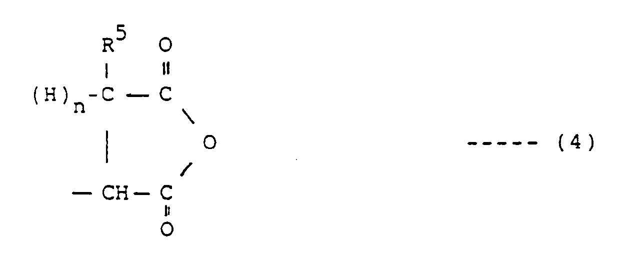 worin R⁵ ein Wasserstoffatom, ein Halogenatom oder einen organischen Rest mit 1 bis 3 C-Atomen bedeutet und n = 0 oder 1 ist, wobei dann, wenn n 0 ist, ein Teil der Hauptkette durch beide C-Atome gebildet wird, von denen eines an R⁵ gebunden und das andere benachbart zu dem einen C-Atom angeordnet und an ein Wasserstoffatom gebunden ist;
danach Reagierenlassen mit einer eine Hydroxylgruppe enthaltenen Verbindung (H), die durch die folgende Formel (5) gekennzeichnet ist:
R¹¹OH (5)
worin R¹¹ ein organischer Rest mit 1 bis 12 C-Atomen oder -Y′-OR˝ ist, worin R˝ eine Alkylgruppe mit 1 bis 10 C-Atomen und Y′ eine Alkylengruppe mit 2 bis 3 C-Atomen bedeuten;
um die durch Formel (4) gekennzeichnete Säureanhydridgruppe in eine Halbestergruppe umzuwandeln, die durch die folgende Formel (6) gekennzeichnet ist: 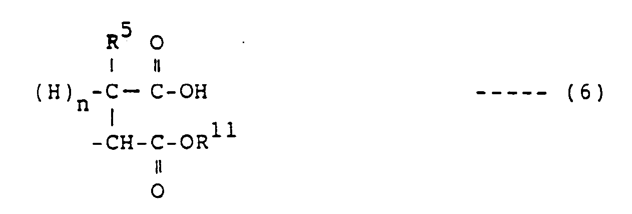 worin R⁵, R¹¹ und n die gleiche Bedeutung haben wie in Formel (4) für R⁵ und n und die gleiche Bedeutung haben wie in Formel (5) für R¹¹;
und danach Reagierenlassen mit einer Diaminverbindung, gekennzeichnet durch die folgende Formel (7): 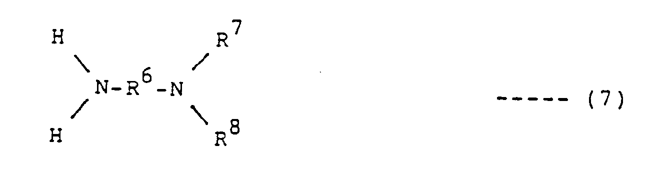 worin R⁶ eine Alkylen- oder Arylenkette mit 1 bis 10 C-Atomen bedeuten und R⁷ und R⁸ aus der gleichen Gruppe oder unterschiedlichen Gruppen bestehen und jeweils einen organischen Rest mit 1 bis 3 C-Atomen bedeuten.

8. Verfahren nach Anspruch 1, bei dem der alkalilösliche anionische Galvano-Ätzresist ein organisches Polymer (IV) umfaßt, das ein Additionsprodukt eines Hauptkettenpolymers (F) mit einem Molekulargewicht von 300 bis 30.000 und einem Jodwert von 50 bis 500 sowie Doppelbindungen ist, wobei eine Halbestergruppe (G) mindestens einem Teil der Doppelbindungen zugesetzt ist, die durch die folgende Formel (8) gekennzeichnet ist: 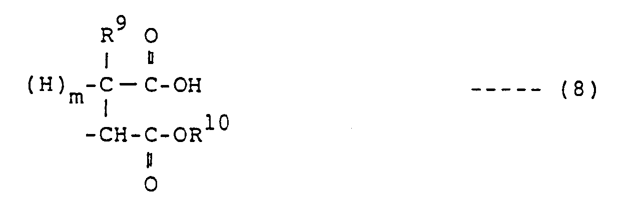 worin R⁹ ein Wasserstoffatom, ein Halogenatom oder ein organischer Rest mit 1 bis 3 C-Atomen ist, R¹⁰ ein organischer Rest mit 1 bis 12 C-Atomen oder eine durch -Y-OR′ gekennzeichnete Gruppe ist, worin R′ eine Alkylgruppe mit 1 bis 10 C-Atomen und Y eine Alkylengruppe mit 2 bis 3 C-Atomen bedeuten, und m 0 oder 1 ist, wobei dann, wenn m 0 ist, ein Teil der Hauptkette durch beide C-Atome gebildet wird, von denen eines an R⁹ gebunden und das andere benachbart zu dem einen C-Atom angeordnet und an ein Wasserstoffatom gebunden ist.

9. Verfahren nach Anspruch 8, bei dem das Hauptkettenpolymer (F) aus der Gruppe ausgewählt wird, die aus natürlichen Ölen und Fetten, Dickölen, Oligomeren von konjugierten Diolefinen, Copolymeren dieser konjugierten Diolefine mit einem niedrigen Polymerisationsgrad, die mit Vinylmonomeren copolymerisiert sind, welche jeweils eine ethylenisch ungesättigte Gruppe aufweisen, Petroleumharzen, Copolymeren von Butadien/Isobutylen mit einem niedrigen Polymerisationsgrad und Gemischen davon besteht.

10. Verfahren nach Anspruch 8, das den Schritt des Zusetzens eines α,β-ungesättigten Dicarbonsäureanhydrides, das aus der Gruppe ausgewählt ist, die aus Maleinsäureanhydrid, Citraconsäureanhydrid, Chloromaleinsäureanhydrid und Gemischen davon besteht, zum Hauptkettenpolymer (F) umfaßt, um eine Säureanhydridgruppe einzuführen, die durch die folgende Formel (9) gekennzeichnet ist: 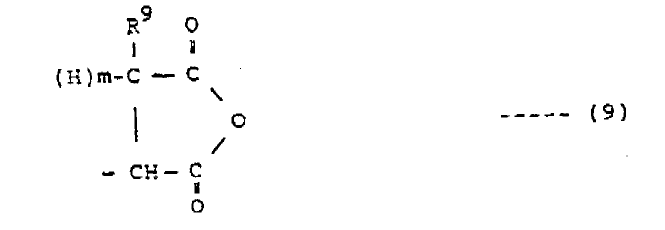 worin R⁹ die Bedeutung von R⁹ in Formel (8) und m die Bedeutung von m in Formel (8) haben;
und danach Reagierenlassen mit einer eine Hydroxylgruppe enthaltenden Verbindung (i), die durch die folgende Formel (10) gekennzeichnet ist:
R¹⁰OH (10)
worin R¹⁰ die Bedeutung von R¹⁰ in Formel (8) besitzt,
um die durch Formel (9) gekennzeichnete Säureanhydridgruppe in die Halbestergruppe (G) umzuwandeln.

## Revendications

1. Procédé pour préparer une plaquette à circuit imprimé à trous ayant au moins un trou, comprenant les étapes :
(a) d'application d'un photorésist d'électrodépôt cationique soluble dans les acides par électrodéposition sur toute une surface d'une plaquette recouverte d'une couche métallique électriquement conductrice comprenant ledit trou tandis que ladite plaquette est montée en cathode ;
(b) de chauffage de la plaquette ayant subi l'étape (a) à une température de 50°C à 120°C ;
(c) d'exposition dudit photorésist d'électrodépôt cationique soluble dans les acides à une lumière à travers un masque de photogravure ayant un motif complémentaire d'un motif d'un circuit qui doit être formé sur la plaquette, pour durcir le photorésist, puis de développement avec un agent de développement pour retirer seulement une partie non durcie dudit photorésist ;
(d) d'application d'un résist de gravure d'électrodépôt anionique soluble dans les alcalis par électrodéposition sur une surface d'une partie de ladite couche métallique électriquement conductrice non revêtue du photorésist durci, tandis que ladite plaquette qui a subi l'étape (c) est montée en anode ;
(e) de chauffage de la plaquette qui a subi l'étape (d) à une température de 50 à 120°C ;
(f) de retrait d'un revêtement dudit photorésist d'électrodépôt cationique soluble dans les acides durci avec une solution acide aqueuse ;
(g) de gravure d'une partie de ladite couche métallique électriquement conductrice exposée par l'étape (f) précédente ; et
(h) de retrait du résist de gravure d'électrodépôt anionique soluble dans les alcalis restant avec une solution alcaline aqueuse.

2. Procédé selon la revendication 1, dans lequel ledit photorésist d'électrodépôt cationique soluble dans les acides est choisi dans le groupe consistant en un photorésist contenant une résine ayant des groupes amino et (méth)acryliques, un photorésist contenant une résine ayant un groupe amino et un prépolymère photosensible, et leurs mélanges.

3. Procédé selon la revendication 2, dans lequel ledit photorésist contenant une résine ayant des groupes amino et (méth)acryliques est un photorésist comprenant une résine cationique contenant des groupes (méth)acryliques (I) et un amorçeur de photopolymérisation, ladite résine cationique contenant des groupes (méth)acryliques (I) étant préparée par réaction d'un polymère (A) ayant une masse moléculaire de 500 à 5 000, un indice d'iode de 50 à 500, une double liaison carbone-carbone et 3 à 12% en masse d'oxygène oxyranique avec un composé aminé (B) représenté par la formule (1) suivante : 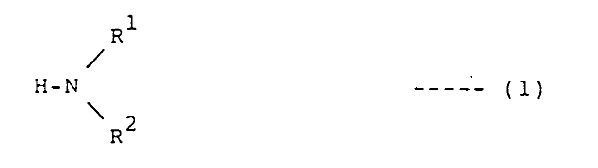 dans laquelle R¹ et R² peuvent être des groupes identiques ou différents et représentent chacun un résidu organique ayant 1 à 20 atomes de carbone ou un résidu organique ayant 1 à 20 atomes de carbone et ayant une partie substituée par un groupe hydroxyle, avec ou sans formation d'une structure annulaire par lesdits groupes R¹ et R² et en présence ou en l'absence d'un groupe insaturé dans ladite structure annulaire ;
puis par réaction avec un acide carboxylique α,β-insaturé (C) représenté par la formule (2) suivante : 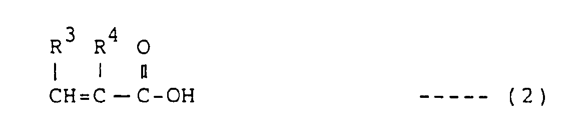 dans laquelle R³ et R⁴ peuvent être des groupes identiques ou différents et représentent chacun un atome d'hydrogène ou un groupe méthyle.

4. Procédé selon la revendication 3, dans lequel ledit polymère (A) est un polymère préparé par époxydation d'un polymère organique initial ayant une masse moléculaire de 500 à 5 000, un indice d'iode de 50 à 500 et ayant une double liaison carbone-carbone au moyen d'un peroxyde choisi dans le groupe consistant en le peroxyde d'hydrogène, l'acide performique, l'acide peracétique, l'acide m-chloroperbenzoïque et leurs mélanges pour introduire ledit oxygène oxyranique en une quantité, calculée en oxygène, de 3 à 12% en masse, ledit polymère organique initial étant préparé par une polymérisation anionique d'un monomère choisi dans le groupe consistant en les dioléfines conjuguées ayant chacune 4 à 10 atomes de carbone, les mélanges d'une ou plusieurs dioléfines conjuguées ayant chacune 4 à 10 atomes de carbone et les mélanges d'une ou plusieurs desdites dioléfines conjuguées avec pas plus de 50 mol% de monomères vinyliques aromatiques, et ladite polymérisation anionique étant réalisée dans un domaine de températures de 0°C à 100°C en présence d'un catalyseur choisi dans le groupe consistant en les métaux alcalins, les composés organiques des métaux alcalins et leurs mélanges.

5. Procédé selon la revendication 2, dans lequel ledit photorésist contenant une résine ayant un groupe amino et un prépolymère photosensible comprend une polyamine (II) ayant un groupe (E) représenté par la formule (3) suivante : 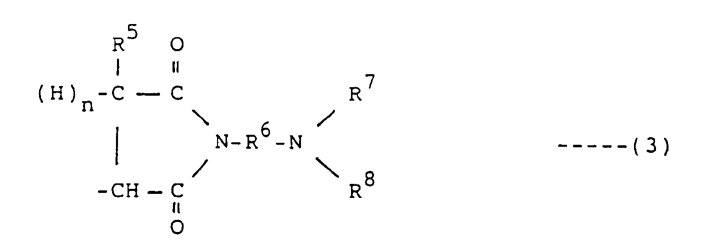 dans laquelle R⁵ représente un atome d'hydrogène, un atome d'halogène ou un résidu organique ayant 1 à 3 atomes de carbone, R⁶ représente une chaîne alkylène ou arylène ayant 1 à 10 atomes de carbone, R⁷ et R⁸ peuvent être des groupes identiques ou différents et représentent chacun un résidu organique ayant 1 à 3 atomes de carbone, et n est 0 (zéro) ou 1 et lorsque n est zéro une partie de la chaîne principale est formée par deux atomes de carbone, l'un étant lié à R⁵ et l'autre étant adjacent audit atome de carbone et étant lié à un atome d'hydrogène ;
ledit groupe (E) étant introduit au moins au niveau d'une partie d'une double liaison d'un polymère de chaîne principale (D) ayant une masse moléculaire de 300 à 30 000 et un indice d'iode de 50 à 500 et comprenant des doubles liaisons carbone-carbone, un prépolymère photosensible (III) ayant une double liaison éthylénique et un amorceur de photopolymérisation.

6. Procédé selon la revendication 5, dans lequel ledit polymère de chaîne principale (D) est choisi dans le groupe consistant en les huiles et graisses naturelles, les standolies, les oligomères de dioléfines conjuguées, les copolymères desdites dioléfines conjuguées ayant un faible degré de polymérisation copolymérisées avec des monomères vinyliques ayant chacun un groupe éthyléniquement insaturé, les résines de pétrole, les copolymères de butadiène/isobutylène ayant un faible degré de polymérisation, et leurs mélanges.

7. Procédé selon la revendication 5, dans lequel ladite polyamine (II) est préparée par les étapes d'addition d'un anhydride dicarboxylique α,β-insaturé choisi dans le groupe consistant en l'anhydride maléique, l'anhydride citraconique, l'anhydride chloromaléique et leurs mélanges audit polymère de chaîne principale (D), d'introduction d'un groupe anhydride d'acide représenté par la formule (4) suivante : 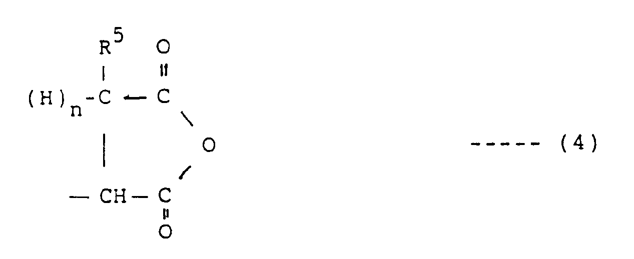 dans laquelle R⁵ représente un atome d'hydrogène, un atome d'halogène ou un résidu organique ayant 1 à 3 atomes de carbone, et n est 0 (zéro) ou 1 et lorsque n est zéro une partie de la chaîne principale est formée par deux atomes de carbone, l'un étant lié à R⁵ et l'autre étant adjacent audit atome de carbone et étant lié à un atome d'hydrogène ;
puis de réaction avec un composé hydroxylé (H) représenté par la formule (5) suivante :
R¹¹OH (5)
dans laquelle R¹¹ est un résidu organique ayant 1 à 12 atomes de carbone, ou -Y′-OR˝ où R˝ est un groupe alkyle ayant 1 à 10 atomes de carbone et Y′ est un groupe alkylène ayant 2 à 3 atomes de carbone,
pour convertir le groupe anhydride d'acide représenté par la formule (4) en un groupe semi-ester représenté par la formule (6) suivante : 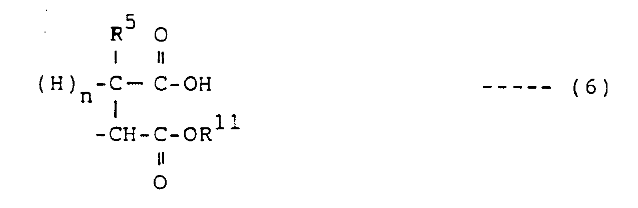 dans laquelle R⁵, R¹¹ et n sont tels que définis dans la formule (4) pour R⁵ et n et tels que définis dans la formule (5) pour R¹¹,
puis de réaction avec un composé diaminé représenté par la formule (7) : 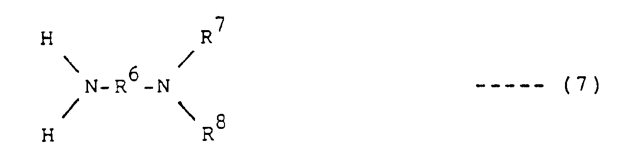 dans laquelle R⁶ est une chaîne alkylène ou arylène ayant 1 à 10 atomes de carbone et R⁷ et R⁸ sont des groupes identiques ou différents et représentent chacun un résidu organique ayant 1 à 3 atomes de carbone.

8. Procédé selon la revendication 1, dans lequel ledit résist de gravure d'électrodépôt anionique soluble dans les alcalis comprend un polymère organique (IV) qui est un produit d'addition d'un polymère de chaîne principale (F) ayant une masse moléculaire de 300 à 30 000 et un indice d'iode de 50 à 500 et ayant des doubles liaisons, un groupe semi-ester (G) étant ajouté au moins au niveau d'une partie desdites doubles liaisons, ledit groupe semi-ester (G) étant représenté par la formule (8) suivante : 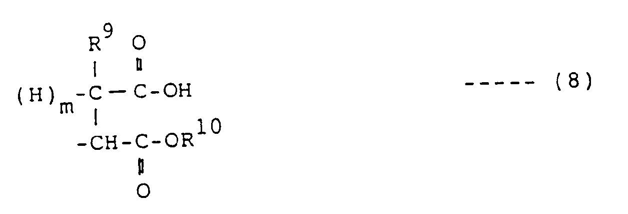 dans laquelle R⁹ représente un atome d'hydrogène, un atome d'halogène ou un résidu organique ayant 1 à 3 atomes de carbone, R¹⁰ représente un résidu organique ayant 1 à 12 atomes de carbone ou un groupe représenté par -Y-OR′ où R′ représente un groupe alkyle ayant 1 à 10 atomes de carbone et Y représente un groupe alkylène ayant 2 à 3 atomes de carbone, et m est 0 (zéro) ou 1 et lorsque m est zéro une partie de la chaîne principale est formée par 2 atomes de carbone, l'un étant lié à R⁹ et l'autre étant adjacent audit atome de carbone et étant lié à un atome d'hydrogène.

9. Procédé selon la revendication 8, dans lequel ledit polymère de chaîne principale (F) est choisi dans le groupe consistant en les huiles et graisses naturelles, les standolies, les oligomères de dioléfines conjuguées, les copolymères desdites dioléfines conjuguées ayant un faible degré de polymérisation copolymérisées avec des monomères vinyliques ayant chacun un groupe éthyléniquement insaturé, les résines de pétrole, les copolymères de butadiène/isobutylène ayant un faible degré de polymérisation, et leurs mélanges.

10. Procédé selon la revendication 8, comprenant l'étape d'addition d'un anhydride dicarboxylique α,β-insaturé choisi dans le groupe consistant en l'anhydride maléique, l'anhydride citraconique, l'anhydride chloromaléique et leurs mélanges audit polymère de chaîne principale (F) pour introduire un groupe anhydride d'acide représenté par la formule (9) suivante : 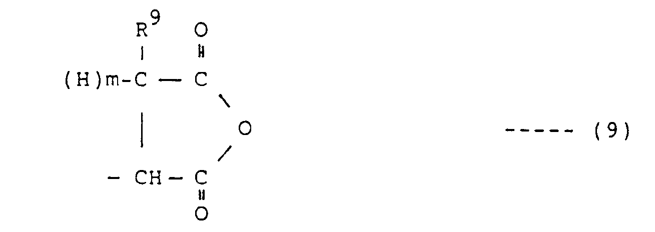 dans laquelle R⁹ représente R⁹ dans ladite formule (8) et m représente m dans ladite formule (8),
puis de réaction avec un composé hydroxylé (i) représenté par la formule (10) suivante :
R¹⁰OH (10)
dans laquelle R¹⁰ représente R¹⁰ dans ladite formule (8) pour convertir le groupe anhydride d'acide représenté par la formule (9) en ledit groupe semi-ester (G).
